Europäisches Patentamt

European Patent Office

Office européen des brevets

(19)

(11) EP 0 876 645 B1

## (12) FASCICULE DE BREVET EUROPEEN

(45) Date de publication et mention
de la délivrance du brevet:
**17.11.1999 Bulletin 1999/46**

(21) Numéro de dépôt: **97901129.3**

(22) Date de dépôt: **21.01.1997**

(51) Int Cl.$^6$: **G06F 7/72**

(86) Numéro de dépôt international:
**PCT/FR97/00111**

(87) Numéro de publication internationale:
**WO 97/27535 (31.07.1997 Gazette 1997/33)**

(54) **CIRCUIT MULTIPLIEUR SUR UN CORPS DE GALOIS, CIRCUIT DE CALCUL DE SYNDROME ET CIRCUIT DE RECHERCHE DE CHIEN**

SCHALTKREIS ZUR MULTIPLIKATION IM GALOIS-FELD, SCHALTKREIS ZUR SYNDROMBERECHNUNG UND SCHALTKREIS ZUR AUSFÜHRUNG EINER CHIEN SEARCH

CIRCUIT FOR MULTIPLYING NUMBERS DEFINED IN A GALOIS-FIELD, CIRCUIT FOR CALCULATING SYNDROMES AND CIRCUIT FOR PERFORMING A CHIEN SEARCH

(84) Etats contractants désignés:
**AT BE CH DE DK ES FI FR GB GR IE IT LI LU MC NL PT SE**

(30) Priorité: **24.01.1996 FR 9600797**

(43) Date de publication de la demande:
**11.11.1998 Bulletin 1998/46**

(73) Titulaire: **THOMCAST
78700 Conflans-Sainte-Honorine (FR)**

(72) Inventeurs:
• **MA, Jian-Jun
F-91940 Les Ulis (FR)**
• **MARCZAK, Jean-Marc
F-78470 Saint-Rémy-les-Chevreuse (FR)**

(74) Mandataire: **Loisel, Bertrand
Cabinet Plasseraud,
84, rue d'Amsterdam
75440 Paris Cédex 09 (FR)**

(56) Documents cités:
**EP-A- 0 271 082**

• **ELEKTROTECHNIK UND INFORMATIONSTECHNIK, vol. 105, no. 1, Janvier 1988, WIEN AT, pages 12-18, XP002014793 T. BETH ET AL.: "Kryptologie und Datensicherheit, Teil II"**
• **TRANSACTIONS OF THE INSTITUTE OF ELECTRONICS, INFORMATION AND COMMUNICATION ENGINEERS OF JAPAN, vol. E73, no. 8, 1 Août 1990, pages 1314-1318, XP000167903 MASAKATU MORII ET AL: "BIT-SERIAL SQUARER IN FINITE FIELDS WITH CHARACTERISTIC 2"**
• **IBM TECHNICAL DISCLOSURE BULLETIN, vol. 12, no. 8, Janvier 1970, NEW YORK US, pages 1183-1185, XP002014794 M. HSIAO: "parallel multiplication in Galois fields"**
• **IEEE TRANSACTIONS ON COMPUTERS, vol. 37, no. 6, 1 Juin 1988, pages 735-739, XP000576196 HSU I S ET AL: "A COMPARISON OF VLSI ARCHITECTURE OF FINITE FIELD MULTIPLIERS USING DUAL, NORMAL, OR STANDARD BASES" cité dans la demande**

EP 0 876 645 B1

**Description**

La présente invention concerne un circuit multiplieur sur un corps de Galois et des applications de ce circuit dans des décodeurs correcteurs d'erreurs.

Des calculs arithmétiques sur les corps de Galois sont utiles dans un certain nombre d'applications. Une application importante est dans la réalisation de codeurs et de décodeurs correcteurs d'erreurs de transmission faisant appel à des codes cycliques de type BCH et en particulier de type Reed-Solomon (voir "Algebraic Coding Theory" de E.R. Berlekamp, Mc Graw-Hill, New York, 1968). Un autre exemple d'application est dans la réalisation de systèmes de cryptage. Pour la mise en oeuvre de tels calculs, la conception des circuits multiplieurs est un problème-clé en termes de complexité du système et de vitesse d'exécution. Ces circuits doivent obéir aux contraintes d'intégration à très grande échelle (VLSI) et permettre de traiter des débits numériques élevés à coût modéré.

On s'intéresse à des corps de Galois CG($2^m$) de cardinal $2^m$, où m est un entier plus grand que 1. On note f $(x)=x^m+f_{m-1}x^{m-1}+f_{m-2}x^{m-2}+...+f_1x+f_0$ le polynôme générateur de degré m utilisé pour construire le corps de Galois CG ($2^m$), dont les coefficients $f_i$ ($0 \leq i < m$) sont dans le corps CG(2) (soit $f_i=0$ ou 1) avec $f_0=1$, et $\alpha$ un élément primitif de CG ($2^m$) qui est une racine du polynôme f(x). Les puissances successives $\alpha^i$ (pour $0 \leq i < 2^m-1$) de $\alpha$ définissent les $2^m-1$ éléments non nuls de CG($2^m$).

Une base dite standard du corps CG($2^m$) associée à l'élément primitif $\alpha$ est constituée par les éléments $\alpha^0=1$, $\alpha^1=\alpha, \alpha^2,...,\alpha^{m-1}$. Tout élément A du corps de Galois CG($2^m$) peut être représenté par un unique m-uplet de bits ($a_0$, $a_1,..., a_{m-1}$) constituant les coordonnées de A dans la base standard $\{1, \alpha, ..., \alpha^{m-1}\}$:

$$A = \sum_{i=0}^{m-1} a_i \, \alpha^i \qquad\qquad (1)$$

D'autres bases peuvent être définies sur le corps de Galois CG($2^m$). En effet, comme le corps CG($2^m$) peut également être considéré comme un espace vectoriel de dimension m sur le corps CG(2), tout m-uplet d'éléments linéairement indépendants de CG($2^m$) en constitue une base. En particulier, on peut définir une base $\{\beta_0, \beta_1,...,\beta_{m-1}\}$ dite duale de la base standard $\{1, \alpha,...,\alpha^{m-1}\}$ à partir des propriétés d'une fonction "trace" notée *Tr(.)* définie, pour tout élément x de CG($2^m$), par :

$$Tr(x) = \sum_{i=0}^{m-1} (x^2)^i$$

Cette fonction *Tr* est linéaire et prend ses valeurs dans CG(2). La base duale de la base standard $\{1, \alpha,..., \alpha^{m-1}\}$ est l'unique m-uplet $\{\beta_0, \beta_1,...,\beta_{m+1}\}$ d'éléments de CG($2^m$) tel que Tr($\alpha^i\beta_i$)=1 et Tr($\alpha^i\beta_k$)=0 pour $0 \leq i,k \leq m-1$ et $1 \neq k$. Tout élément B du corps CG($2^m$) peut être représenté par un unique m-uplet de bits ($b'_0, b'_1,...,b'_{m-1}$) constituant ses coordonnées dans la base duale $[\beta_0, \beta_1,...,\beta_{m-1}\}$ :

$$B = \sum_{i=0}^{m-1} b'_i \, \beta_i \qquad\qquad (2)$$

avec $b'_i=Tr(B\alpha^i)$.

Dans l'article "Bit-Serial Reed-Solomon Encoders" (IEEE Trans. on Information Theory, Vol. IT-28, N°6, novembre 1982), E.R. Berlekamp a présenté un circuit multiplieur utilisable dans des codeurs Reed-Solomon, dans lequel l'un des opérandes A est représenté en base standard (relation (1)), l'autre opérande B est représenté en base duale (relation (2)), et le résultat C=AB est produit en base duale :

$$C = \sum_{i=0}^{m-1} c'_i \, \beta_i \qquad\qquad (3)$$

Ce circuit multiplieur en base duale délivre en série les coordonnées en base duale du produit C=AB des deux opérandes en m cycles d'horloge, à raison d'un bit par cycle en commençant par le bit de poids le plus faible.

De tels multiplieurs en base duale ont été introduits pour la réalisation de codeurs Reed-Solomon. Dans les multiplications réalisées par un codeur Reed-Solomon, l'un des opérandes est fixe : celui correspondant à un coefficient du polynôme générateur du code. Il est commode d'exprimer ce coefficient sur la base standard (opérande A). Ceci permet de limiter le nombre de portes logiques nécessaires. C'est ce dernier mode de réalisation qui est décrit dans l'article précité de E.R. Berlekamp (voir aussi le brevet européen 0 066 618). Le cas où l'opérande A peut changer d'une multiplication à une autre est décrit dans l'article "A comparison of VLSI Architecture for Finite Fields Multipliers Using Dual, Normal, or Standard Bases" de I.S. Hsu et al, IEEE Trans. on Computers, Vol. 37, n°6, juin 1988.

Parmi les circuits multiplieurs connus, le multiplieur en base duale est le plus performant en termes de nombre de portes logiques nécessaires à sa réalisation et en termes de cadence de traitement. Dès l'initialisation des registres du multiplieur, le premier bit de sortie est disponible. Il a en outre l'avantage de produire le résultat en série, ce qui facilite sa mise en oeuvre dans des systèmes à organisation en pipe-line.

La présente invention trouve des applications, en particulier, dans des décodeurs Reed-Solomon. On s'intéresse à un code de Reed-Solomon RS (N, N-2t, t) défini sur le corps de Galois $CG(2^m)$. Un code de Reed-Solomon est un code cyclique en blocs dont le polynôme générateur g(x) de degré 2t à coefficients dans $CG(2^m)$ a pour racines 2t puissances consécutives d'un élément primitif $\psi$ du corps $CG(2^m)$, $\psi$ pouvant être égal à $\alpha$ ou plus généralement à toute racine du polynôme f(x) générateur du corps :

$$g(x) = \prod_{i=0}^{2t-1} (x - \psi^{I+i}) \quad ,$$

I étant une constante entière. Chaque mot de code se compose de N symboles ($N<2^m$) du corps $CG(2^m)$ qui représentent N-2t symboles d'information indépendants. Le nombre t est le nombre maximum de symboles erronés que le code permet de corriger algébriquement. Chaque bloc reçu par le décodeur se compose de N symboles de $CG(2^m)$ $r_0, r_1,..., r_{N-1}$ définissant le polynôme :

$$R(x) = r_{N-1} x^{N-1} + ... + r_1 x + r_0$$

En l'absence d'erreurs sur les symboles reçus, le polynôme générateur du code g(x) est un facteur de ce polynôme R(x).

Les méthodes de décodage font généralement intervenir des calculs de syndromes d'erreur. Un syndrome est une valeur du polynôme R(x) pour un élément donné du corps de Galois. Le plus souvent, on se limite au calcul des syndromes pour les 2t racines du polynôme générateur du code : $S_i = R(\psi^{I+i})$ pour $0 \le i \le 2t-1$. Si le bloc reçu comporte V symboles erronés $r_h(0), r_h(1),..., r_{h(V-1)}$ ($V \le t$ et $0 \le h(v) \le N-1$ pour $0 \le v \le V-1$), alors chaque syndrome $S_i$ vérifie :

$$S_i = \sum_{v=0}^{V-1} \psi^{(I+i)h(v)} \cdot e_{h(v)} \qquad\qquad (4)$$

où $e_{h(v)}$ désigne l'amplitude de l'erreur sur le symbole $r_{h(v)}$.

Une manière commode de calculer un syndrome $S_i$ est d'utiliser un circuit consistant essentiellement en un multiplieur, un additionneur et un registre pour mettre en oeuvre la relation de récurrence

$$S_i^{(n)} = S_i^{(n-1)} \cdot \psi^{I+i} + r_{N-1-n} \qquad\qquad (5)$$

Avec la condition d'initialisation $S_i^{(0)} = r_{N-1}$, le syndrome $S_i$ est calculé au fur et à mesure de l'arrivée des symboles $r_{N-1-n}$ (dans l'ordre des poids décroissants), et obtenu dès l'arrivée du dernier symbole $r_0$ du bloc : $S_i = S_i^{(N-1)}$.

Les 2t relations (4) ont 2V inconnues, à savoir les positions h(v) et les amplitudes $e_{h(v)}$ des erreurs. Pour résoudre ces équations, la plupart des algorithmes de décodage impliquent le calcul d'un polynôme localisateur d'erreurs a(x) de degré V dont les racines sont les éléments du corps de Galois de la forme $\psi^{-h(v)}$. L'expression du polynôme localisateur d'erreurs est :

$$\sigma(x) = \kappa \cdot \prod_{v=0}^{V-1} (1 - x\psi^{h(v)}) = \sigma_t x^t + \sigma_{t-1} x^{t-1} + \ldots + \sigma_1 x + \sigma_0$$

où $\kappa = \sigma_0$ est un élément arbitraire du corps CG($2^m$) et $\sigma_u = 0$ pour u>V. Les coefficients de ce polynôme vérifient le système linéaire :

$$
\begin{pmatrix}
S_0 & S_1 & \cdot & \cdot & \cdot & S_{V-1} \\
S_1 & S_2 & \cdot & \cdot & \cdot & S_V \\
\cdot & \cdot & \cdot & & & \cdot \\
\cdot & \cdot & & \cdot & & \cdot \\
\cdot & \cdot & & & \cdot & \cdot \\
S_{V-1} & S_V & \cdot & \cdot & \cdot & S_{2V-2}
\end{pmatrix}
\begin{pmatrix}
\sigma_V \\
\sigma_{V-1} \\
\cdot \\
\cdot \\
\cdot \\
\sigma_1
\end{pmatrix}
= \kappa
\begin{pmatrix}
S_V \\
S_{V+1} \\
\cdot \\
\cdot \\
\cdot \\
S_{2V-1}
\end{pmatrix}
\qquad (6)
$$

Différents algorithmes existent pour résoudre le système linéaire (6), notamment l'algorithme d'Euclide et les algorithmes de type Berlekamp-Massey. L'algorithme d'Euclide est conceptuellement simple, mais sa mise en oeuvre dans un circuit VLSI requiert une complexité plus grande (en termes de nombre de portes logiques) que les algorithmes de type Berlekamp-Massey. Les algorithmes de type Berlekamp-Massey résolvent l'équation (6) en 2t itérations successives qui s'interprètent classiquement comme une construction récursive d'un registre à décalage à opérateurs linéaires modélisant le système (6) . Dans une version traditionnelle de l'algorithme de Berlekamp-Massey (voir "Theory and Practice of Error Control Codes" de R.E. Blahut, Addison-Wesley, Reading, MA, 1993), on utilise les variables suivantes :

- polynôme localisateur $\sigma^{(k)}(x)$ égal à $\sigma(x)$ au terme des 2t itérations (initialement $\sigma^{(0)}(x)=1$) ;
- polynôme intermédiaire $\lambda^{(k)}(x)$ servant à la mise à jour du polynôme localisateur lors des itérations (initialement $\lambda^{(0)}(x)=1$) ;
- $L_k$ : variable entière représentant le degré de $\sigma^{(k)}(x)$ (initialement $L_0=0$) ;
- écart de prédiction ("discrepancy") $\Delta_k$ à valeurs dans le corps CG($2^m$) ; et
- $\delta_k$ : variable binaire,

et les calculs effectués à chaque itération k ($1 \leq k \leq 2t$) sont :

$$\Delta_k = \sum_{u=0}^{t} \sigma_u^{(k-1)} S_{k-u-1} \qquad (7.1)$$

$$\delta_k = \begin{cases} 0 \text{ si } \Delta_k = 0 \text{ ou } 2L_{k-1} > k-1 \\ 1 \text{ si } \Delta_k \neq 0 \text{ et } 2L_{k-1} \leq k-1 \end{cases} \qquad (7.2)$$

$$L_k = \delta_k(k-L_{k-1}) + (1-\delta_k)L_{k-1} \qquad (7.3)$$

$$\sigma^{(k)}(x) = \sigma^{(k-1)}(x) - \Delta_k.x.\lambda^{(k-1)}(x) \tag{7.4}$$

$$\lambda^{(k)}(x) = \delta_k\Delta_k^{-1}\sigma^{(k-1)}(x) + (1-\delta_k)x.\lambda^{(k-1)}(x) \tag{7.5}$$

Diverses variantes de l'algorithme de Berlekamp-Massey ont été proposées dans le but de simplifier son implémentation. On pourra par exemple consulter à cet égard l'article "Time Domain Algorithm and Architecture for Reed-Solomon Decoding", de S. Choomchuay et al, IEEE Proceedings-I, Vol. 140, N°3, juin 1993, pages 189-196, ou encore le document WO95/12850. L'article "VLSI Design of Inverse-Free Berlekamp-Massey Algorithm", de I.S. Reed et al, IEEE Proceedings-E, Vol.138, N° 5, Septembre 1991, pages 295-298, propose une variante intéressante dans la mesure où elle permet de se dispenser de calculer l'inverse $\Delta_k^{-1}$ de l'écart de prédiction (cf. équation 7.5). Cette variante revient à considérer une valeur a priori quelconque dans $CG(2^m)$ pour le coefficient $\kappa=\sigma_0$, au lieu de $\kappa=1$ dans la version traditionnelle énoncée ci-dessus.

Une fois que le polynôme localisateur d'erreurs a été calculé, ses racines sont déterminées pour obtenir les positions h(v) des erreurs. Un procédure fréquemment utilisée pour cela, dite "recherche de Chien", consiste à calculer les valeurs du polynôme $\sigma(x)$ pour chacun des éléments du corps $CG(2^m)$, une erreur étant identifiée chaque fois que $\sigma(x)=0$ (voir "Cyclic Decoding Procedure for the Bose-Chaudhuri-Hocquenghem Codes" par R.T. Chien, IEEE Trans. on Information Theory, Vol.10, 1964, pages 357-363). Cette procédure consiste en un calcul récursif des valeurs $\sigma(\psi^{1-N+n})$ pour n=0, 1,..., N-1 selon :

$$\sigma(\psi^{1-N+n}) = \sum_{u=0}^{t} \zeta_u(n) \tag{8}$$

en exploitant les relations de récurrence :

$$\zeta_u^{(n+1)} = \zeta_u^{(n)}.\psi^u \tag{9}$$

initialisées par :

$$\zeta_u^0 = \sigma_u.\psi^{u(1-N)}$$

Les amplitudes des erreurs sont par exemple évaluées selon l'algorithme de Forney (Voir "On Decoding BCH Codes", par G.D. Forney, IEEE Trans. on Information Theory, Vol.II, 1965, pages 549-557). Un polynôme évaluateur d'erreurs $\omega(x)$ est défini par l'équation-clé :

$$\omega(x) = [1+x.S(x)].\sigma(x) \bmod x^{2t}$$
$$= \omega_t.x^t+\omega_{t-1}x^{t-1}+...+\omega_1 x + \omega_0, \tag{10}$$

S(x) désignant le polynôme des syndromes :

$$S(x) = \sum_{i=0}^{2t-1} S_i.x^i$$

Les amplitudes des erreurs sont alors obtenues par :

$$e_{h(v)} = \frac{x^{I-1} \, \omega(x)}{x \, \sigma'(x)} \qquad \text{pour } x = \psi^{-h(v)} \tag{11}$$

$\sigma'(x)$ désignant la dérivée du polynôme localisateur d'erreurs. Les valeurs du dénominateur $\psi^{1-N+n}\sigma'(\psi^{1-N+n})$ pour $n=0,1,...,N-1$ peuvent être obtenues simplement lors de la recherche de Chien (par une somme telle que (8) dans laquelle seuls les termes pour u impair sont sommés). Les valeurs du numérateur $\psi^{(I-1)(1-N+n)}\omega(\psi^{1-N+n})$ peuvent être obtenues par une procédure semblable à la recherche de Chien pour n=0,1, ...., N-1, étant donné que

$$\psi^{(I-1)(1-N+n)} \, \omega(\psi^{1-N+n}) \; = \; \sum_{u=0}^{t} \xi_u^{(n)} \tag{12}$$

avec les relations de récurrence :

$$\xi_u^{(n+1)} = \xi_u^{(n)}.\psi^{u+I-1} \tag{13}$$

initialisées par :

$$\xi_u^{(0)} = \omega_u.\psi^{(u+I-1)(1-N)}$$

Lorsque l'équation-clé est résolue selon un algorithme de type Berlekamp-Massey, les coefficients du polynôme évaluateur $\omega(x)$ peuvent être calculés lors des 2t itérations de cet algorithme. Dans le cas de la version traditionnelle de l'algorithme énoncée ci-dessus, le polynôme évaluateur $\omega^{(k)}(x)$ est initialisé par $\omega^{(0)}(x)=1$, un autre polynôme intermédiaire $\mu^{(k)}(x)$ est initialisé par $\mu^{(0)}(x)=0$, et chaque itération k ($1 \leq k \leq 2t$) comporte, en plus des calculs (7.1) à (7.5), une mise à jour des polynômes $\omega^{(k)}(x)$ et $\mu^{(k)}(x)$ selon des relations semblables à (7.4) et (7.5) conduisant à $\omega^{(2t)}(x)=\omega(x)$ :

$$\omega^{(k)}(x) = \omega^{(k-1)}(x) - \Delta_k.x.\mu^{(k-1)}(x) \tag{7.6}$$

$$\mu^{(k)}(x) = \delta_k \, \Delta_k^{-1} \, \omega^{(k-1)}(x)+(1-\delta_k)x.\mu^{(k-1)}(x) \tag{7.7}$$

Le procédé de décodage dont les grandes lignes ont été rappelées ci-dessus s'accomode bien d'une organisation en pipe-line pour réduire le temps de décodage et les capacités de mémoire tampon requises : pendant qu'une partie du circuit décodeur résout l'équation-clé à l'égard d'un bloc courant, une autre partie du circuit calcule les syndromes pour le bloc suivant et une autre partie encore procède aux corrections pour le bloc précédent.

Les décodeurs actuels doivent permettre de traiter les débits d'information très élevés, pouvant atteindre la centaine de mégabits par seconde (Mbit/s). Atteindre de telles cadences de traitement avec des circuits VLSI destinés au grand public est un défi majeur pour les concepteurs de décodeurs. Le calcul des syndromes et la recherche de racines selon l'algorithme de Chien sont deux étapes cruciales en termes de débit, l'un en raison du débit d'entrée à traiter, l'autre en raison du débit auquel il faut produire les évaluations des erreurs. Les circuits multiplieurs constituent à cet égard un facteur de limitation : comme ils produisent au plus un bit par cycle d'horloge et comme les fréquences d'horloge sont limitées par la technologie, on est obligé d'augmenter sensiblement le nombre de composants pour réaliser des calculs en parallèle. Outre l'augmentation de la complexité, de tels calculs en parallèle ont l'inconvénient d'être mal adaptés aux algorithmes récursifs optimaux tels qu'exprimés par la relation (5) pour le calcul des syndromes ou par les relations (8), (9), (12) et (13) pour les calculs de racines.

Un but de la présente invention est de proposer un circuit multiplieur en base duale permettant de réduire la durée nécessaire pour produire le résultat d'une multiplication sur un corps de Galois.

L'invention propose ainsi un circuit multiplieur pour délivrer le produit de premier et second opérandes sur un corps de Galois de cardinal $2^m$, m étant un entier plus grand que 1, le premier opérande A étant représenté, dans une base standard $\{1,\alpha,...,\alpha^{m-1}\}$ du corps de Galois, par m coordonnées binaires $a_0,a_1,...,a_{m-1}$ telles que $A=a_0+a_1\alpha+ ... +a_{m-1}\alpha^{m-1}$, $\alpha$ désignant une racine d'un polynôme générateur $f(x)=x^m+f_{m-1}x^{m-1}+...+f_1x+f_0$ du corps de Galois dont les

coefficients $f_0, f_1, ..., f_{m-1}$ sont des bits de valeurs prédéterminées, le second opérande B étant représenté, dans une base $\{\beta_0, \beta_1, ..., \beta_{m-1}\}$ du corps de Galois qui est une base duale de ladite base standard, par m coordonnées binaires $b'_0, b'_1, ..., b'_{m-1}$ telles que $B = b'_0\beta_0 + b'_1\beta_1 + ... + b'_{m-1}\beta_{m-1}$, et le produit C=AB des deux opérandes étant représenté, dans ladite base duale, par m coordonnées binaires $c'_0, c'_1, ..., c'_{m-1}$ telles que $C = c'_0\beta_0 + c'_1\beta_1 + ... + c'_{m-1}\beta_{m-1}$. Selon l'invention, le circuit multiplieur comprend :

j registres à décalage $R_0, R_1, ..., R_{j-1}$, j étant un entier plus grand que 1 diviseur de m, chaque registre à décalage $R_q$ $(0 \leq q \leq j-1)$ ayant m/j éléments de mémorisation $M_{0,q}, M_{1,q}, ..., M_{(m/j)-1,q}$ agencés de façon que l'entrée de chaque élément de mémorisation $M_{p,q}$ pour $0 \leq p < (m/j)-1$ soit reliée à la sortie de l'élément de mémorisation $M_{p+1,q}$, $z_{p,q}$ désignant le bit présent en sortie de l'élément de mémorisation $M_{p,q}$ pour $0 \leq p \leq (m/j)-1$, et $z_{m/j,q}$ désignant le bit présent à l'entrée de l'élément de mémorisation $M_{(m/j)-1,q}$ ;

des premiers moyens de logique combinatoire pour adresser, à l'entrée de l'élément de mémorisation $M_{(m/j)-1,r}$ de chaque registre à décalage $R_r$ $(0 \leq r \leq j-1)$, un bit respectif $x'_r$ obtenu par l'addition binaire

$$x'_r = \sum_{p=0}^{m/j-1} \sum_{q=0}^{j-1} x_{p,q,r} \quad ,$$

où $x_{p,q,r} = f_{pj+q-r} \cdot z_{p,q}$ si $0 \leq r \leq q$, et $x_{p,q,r} = f_{(p+1)j+q-r} \cdot z_{p+1,q}$ si $q+1 \leq r \leq j-1$ ; et
des seconds moyens de logique combinatoire pour délivrer, sur chaque sortie $W_r$ $(0 \leq r \leq j-1)$ parmi j sorties $W_0, W_1, ..., W_{j-1}$ du circuit multiplieur, un bit respectif $y'_r$ obtenu par l'addition binaire

$$y'_r = \sum_{p=0}^{m/j-1} \sum_{q=0}^{j-1} y_{p,q,r} \quad ,$$

où $y_{p,q,r} = a_{pj+q-r} \cdot z_{p,q}$ si $0 \leq r \leq q$, et $y_{p,q,r} = a_{(p+1)j+q-r} \cdot z_{p+1,q}$ si $q+1 \leq r \leq j-1$.

Ainsi, en chargeant lors d'un cycle initial k=0 les coordonnées binaires en base duale du second opérande B dans les registres à décalage selon $z_{p,q} = b'_{pj+q}$ pour $0 \leq p \leq m/j-1$ et $0 \leq q \leq j-1$, et en effectuant (m/j)-1 cycles de décalage k=1,...,(m/j)-1 dans les registres $R_q$, on obtient respectivement les coordonnées binaires en base duale $c'_{kj}, c'_{kj+1}, ..., c'_{kj+(j-1)}$ du produit C sur les sorties $W_0, W_1, ..., W_{j-1}$ lors du cycle k $(0 \leq k \leq (m/j)-1)$.

L'invention concerne également des applications d'un tel circuit multiplieur dans un circuit de calcul de syndrome et dans un circuit de recherche de Chien, ces circuits étant utilisables dans des décodeurs Reed-Solomon ou plus généralement dans des décodeurs BCH.

L'invention propose ainsi un circuit de calcul de syndrome fonctionnant en N étapes successives n=0,1,...,N-1 pendant lesquelles sont respectivement reçus des symboles $r_{N-1}, r_{N-2}, ..., r_0$ d'un bloc de signal reçu, chaque symbole étant un élément d'un corps de Galois de cardinal $2^m$, comprenant :

- un circuit multiplieur tel que défini ci-dessus, ayant comme premier opérande un élément constant du corps de Galois pour lequel un syndrome d'erreur est à calculer ;
- un additionneur parallèle sur j bits ayant une première entrée sur j bits recevant lors de chaque étape $n \geq 1$ les coordonnées en base duale du symbole $r_{N-1-n}$ sous forme de m/j groupes successifs de j coordonnées binaires de poids croissants, et une seconde entrée sur j bits recevant les j bits présents sur les j sorties $W_0, ..., W_{j-1}$ du circuit multiplieur ; et
- des moyens pour fournir un second opérande au circuit multiplieur pour chacune des N étapes successives, ledit second opérande étant égal au premier symbole $r_{N-1}$ du bloc pour l'étape 1, et ledit second opérande ayant pour chaque étape $n+1 \geq 2$ des coordonnées binaires en base duale correspondant aux m/j groupes de j bits respectivement délivrés par l'additionneur parallèle lors de la réception des m/j groupes de j coordonnées binaires du symbole $r_{N-1-n}$ au cours de l'étape précédente n,

les coordonnées en base duale du syndrome étant disponibles en sortie de l'additionneur parallèle au cours de la dernière étape N-1.

L'invention propose encore un circuit de recherche de Chien pour calculer en N étapes successives n=0,1,...,

N-1 les valeurs, pour N éléments successifs d'un corps de Galois de cardinal $2^m$, d'une fonction de la forme $x^K.Q(x)$ où K est un entier et Q un polynôme de degré au plus égal à t à coefficients dans ledit corps de Galois, lesdits N éléments successifs étant des puissances consécutives $\psi^{1-N}, \psi^{2-N}, ..., \psi^0$ d'un élément primitif $\psi$ du corps de Galois, comprenant :

> t+1 unités de calcul de rangs respectifs $0,1,...,t$, chaque unité de calcul de rang u ($0 \leq u \leq t$) étant agencée pour délivrer, au cours d'une étape n, m/j groupes successifs de j bits représentant les coordonnées en base duale de l'élément $Q_u.\psi^{(u+K)(1-N+n)}$ du corps de Galois, $Q_u$ désignant le coefficient de degré u dudit polynôme ; et
> des moyens additionneurs parallèles sur j bits recevant les bits délivrés par chacune desdites unités de calcul, de manière à fournir lors de chaque étape n les coordonnées en base duale de la valeur prise par ladite fonction pour l'élément $\psi^{1-N+n}$,
> chaque unité de calcul de rang $u \neq -K$ comportant un circuit multiplieur tel que défini ci-dessus, ayant comme premier opérande l'élément $\psi^{u+K}$ du corps de Galois pour au moins chaque étape $n \geq 1$, et comme second opérande le produit entre le coefficient de degré u dudit polynôme et l'élément $\psi^{(u+K)(1-N)}$ du corps de Galois pour l'étape n=1, et, pour chaque étape $n \geq 2$, le produit délivré lors de l'étape n-1 par ledit circuit multiplieur,
> le produit délivré par chaque circuit multiplieur au cours d'une étape $n \geq 1$ étant adressé à une entrée parallèle sur j bits respective des moyens additionneurs parallèles.

La présente invention sera mieux comprise à la lecture de la description ci-après d'exemples de réalisation non limitatifs, en référence aux dessins annexés, dans lesquels :

- la figure 1 est un schéma synoptique d'un circuit multiplieur selon l'invention ;
- la figure 2 est un schéma d'un élément du circuit de la figure 1 ;
- les figures 3 et 4 sont des schémas de deux exemples de circuits multiplieurs sur le corps de Galois CG($2^8$) ;
- la figure 5 est un schéma de principe d'un registre utilisable dans un décodeur Reed-Solomon mettant en oeuvre l'invention ;
- la figure 6 est un schéma synoptique d'un décodeur Reed-Solomon mettant en oeuvre l'invention ;
- la figure 7 est un schéma d'un circuit de calcul de syndrome du décodeur de la figure 6 ;
- la figure 8 montre des chronogrammes illustrant le fonctionnement du circuit de la figure 7 ;
- la figure 9 est un schéma d'un circuit de résolution d'équation-clé du décodeur de la figure 6 ;
- la figure 10 est un schéma d'une cellule de calcul du circuit de la figure 9 ;
- la figure 11 est un schéma d'un logique de calcul du circuit de la figure 9 destinée à fonctionner avec une cellule de calcul du type représenté sur la figure 10 ;
- la figure 12 montre des chronogrammes illustrant le fonctionnement du circuit des figures 9 à 11 ;
- les figures 13 et 14 sont des schémas analogues aux figures 10 et 11 illustrant une variante du circuit de résolution d'équation-clé ;
- les figures 15 et 16 sont des schémas de circuits de recherche de Chien du décodeur de la figure 6 ;
- la figure 17 montre des chronogrammes illustrant le fonctionnement des circuits des figures 15 et 16 ; et
- la figure 18 est un schéma illustrant une variante d'un circuit de recherche de Chien.

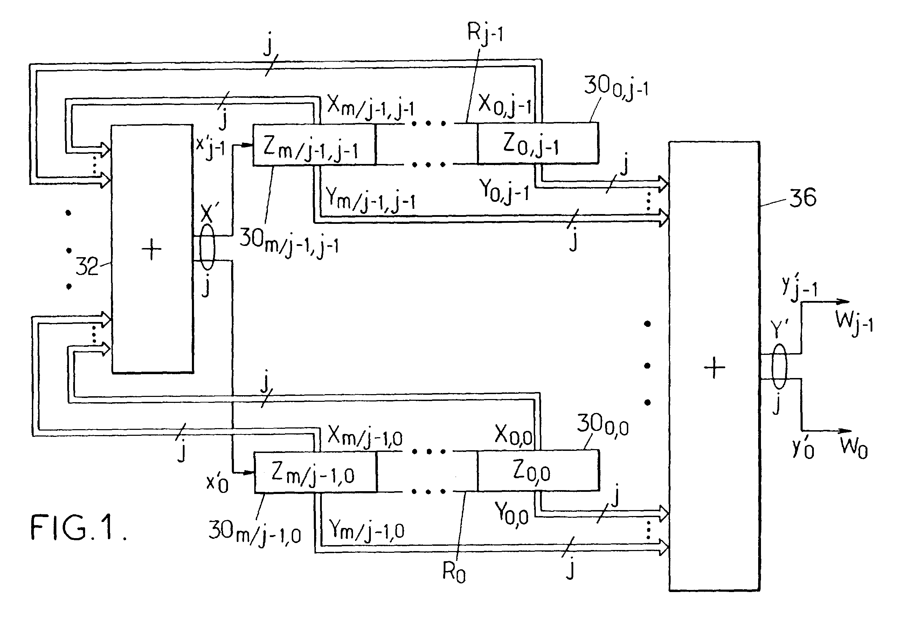

Le circuit de la figure 1 réalise des multiplications sur un corps de Galois CG($2^m$) avec m>1. L'entier j plus grand que 1 désigne un diviseur de m. Le circuit multiplieur comporte j registres à décalage $R_0, R_1, ..., R_{j-1}$.

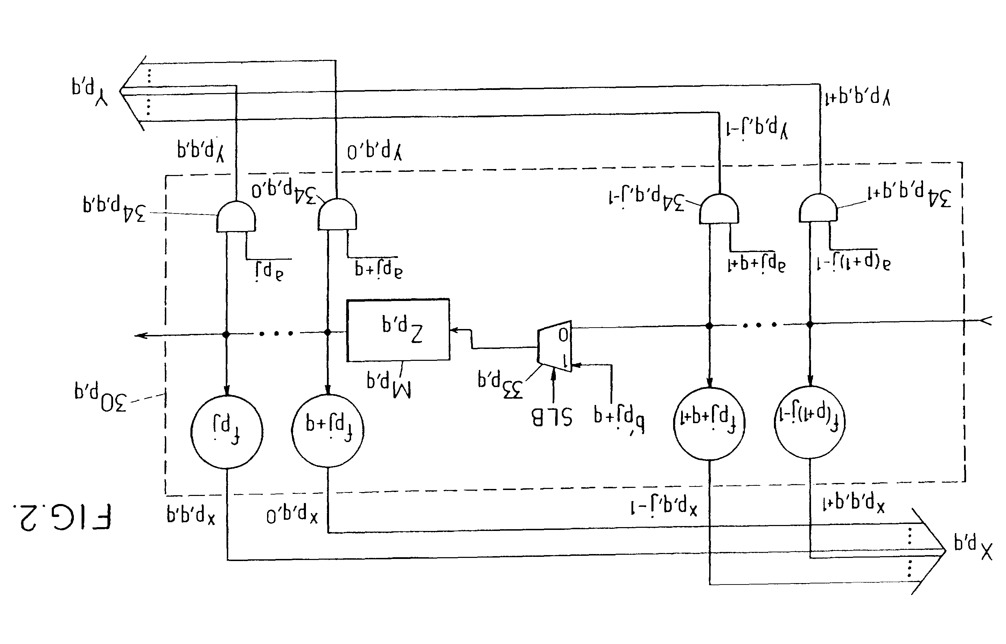

Chacun de ces registres $R_q$ se compose de m/j éléments de mémorisation $M_{0,q}, M_{1,q}, ..., M_{(m/j)-1,q}$. La figure 1 montre des cellules $30_{p,q}$ comportant chacune un élément de mémorisation $M_{p,q}$ du registre $R_q$. Le schéma d'une telle cellule $30_{p,q}$ est montré sur la figure 2. L'élément de mémorisation $M_{p,q}$ ($0 \leq p \leq m/j-1$, $0 \leq q \leq j-1$), consiste typiquement en une bascule D contenant un bit noté $z_{p,q}$ disponible à sa sortie et dont l'entrée est reliée à la sortie d'un multiplexeur $33_{p,q}$. Ces bascules D sont cadencées par une horloge commune. Le multiplexeur $33_{p,q}$ a une première entrée reliée à une entrée du circuit multiplieur recevant la coordonnée en base duale $b'_{pj+q}$ de l'opérande B (relation (2)), et une seconde entrée reliée à la sortie de la bascule $33_{p+1,q}$ si $p<m/j-1$ et à une entrée série du registre à décalage $R_q$ si $p=m/j-1$. Les multiplexeurs $33_{p,q}$ sont commandés par un signal binaire commun SLB qui active les premières entrées lorsque SLB=1 (mode de chargement en parallèle) et les secondes entrées lorsque SLB=0 (mode de décalage en série). On note $z_{m/j,q}$ le bit présent à l'entrée série du registre à décalage $R_q$ ($0 \leq q \leq j-1$).

La cellule $30_{p,q}$ délivre j bits $x_{p,q,0}, x_{p,q,1}, ..., x_{p,q,j-1}$ formant un j-uplet ou vecteur de j bits $x_{p,q}$. Pour $0 \leq r \leq q$, le bit $x_{p,q,r}$ correspond à $f_{pj+q-r}.z_{p,q}$, tandis que pour $q+1 \leq r \leq j-1$, le bit $x_{p,q,r}$ correspond à $f_{(p+1)j+q-r}.z_{p+1,q}$. Etant donné que les positions des bits $f_i$ non nuls sont connues d'après le polynôme primitif retenu pour engendrer le corps CG($2^m$), la cellule $30_{p,q}$ peut se contenter de ne délivrer que les bits $x_{p,q,r}$ correspondant à un coefficient 1 dans le polynôme générateur, soit $x_{p,q,r}=z_{p,q}$ si $0 \leq r \leq q$ et $f_{pj+q-r} \neq 0$, et $x_{p,q,r}=z_{p+1,q}$ si $q+1 \leq r \leq j-1$ et $f_{(p+1)j+q-r} \neq 0$.

Comme le montre la figure 1, une logique combinatoire 32 formant j additionneurs en parallèle fait la somme des vecteurs $X_{p,q}$ ($0 \leq p \leq m/j-1$, $0 \leq q \leq j-1$) pour délivrer un vecteur de j bits $X' = \{x'_0, x'_1, ..., x'_{j-1}\}$. La logique 32 consiste simplement en un groupement de portes OU exclusif, l'additionneur de rang r ($0 \leq r \leq j-1$) réalisant l'addition binaire :

$$x'_r = \sum_{p=0}^{m/j-1} \sum_{q=0}^{j-1} x_{p,q,r}$$

Ce bit $x'_r$ est adressé à l'entrée du registre $R_r$ et correspond donc au bit précédemment appelé $z_{m/j,r}$ qui sera chargé dans la bascule $z_{m/j-1,r}$ lors du prochain cycle de décalage.

Pour initialiser une multiplication, on charge les coordonnées en base duale ($b'_0, b'_1, ..., b'_{m-1}$) de l'opérande B dans les registres $R_q$ en mettant le signal SLB à 1 pendant un cycle d'horloge k=0. Les contenus des registres $R_q$ sont alors : $z_{p,q}^{(0)} = b'_{pj+q} = Tr(B\alpha^{pj+q})$ pour $0 \leq p \leq m/j-1$ et $0 \leq q \leq j-1$. On a par ailleurs pour ce cycle initial k=0 :

$$z_{m/j,0}^{(0)} = x'_0^{(0)} = \sum_{p=0}^{m/j-1} \sum_{q=0}^{j-1} f_{pj+q} \, z_{p,q}^{(0)}$$

$$= \sum_{p=0}^{m/j-1} \sum_{q=0}^{j-1} f_{pj+q} \, Tr(B\alpha^{pj+q})$$

$$= Tr\left(B \sum_{i=0}^{m-1} f_i \alpha^i\right) = Tr(B\alpha^{m+0})$$

Supposons maintenant que l'on ait $z_{m/j,q}^{(0)} = Tr(B\alpha^{m+q})$ pour $0 \leq q \leq r-1 \leq j-1$, ce qui est vrai pour r-1=0 comme on vient de le montrer. On a alors :

$$z_{m/j,r}^{(0)} = x'_r^{(0)}$$

$$= \sum_{p=0}^{m/j-1} \left( \sum_{q=0}^{r-1} f_{(p+1)j+q-r} \, z_{p+1,q}^{(0)} + \sum_{q=r}^{j-1} f_{pj+q-r} \, z_{p,q}^{(0)} \right)$$

$$= \sum_{p=0}^{m/j-1} \left( \sum_{q=0}^{r-1} f_{(p+1)j+q-r} \, Tr(B\alpha^{(p+1)j+q}) + \sum_{q=r}^{j-1} f_{pj+q-r} \, Tr(B\alpha^{pj+q}) \right)$$

$$= Tr\left(B\alpha^r \sum_{p=0}^{m/j-1} \left( \sum_{q'=j-r}^{j-1} f_{pj+q'} \, \alpha^{pj+q'} + \sum_{q'=0}^{j-r-1} f_{pj+q'} \, \alpha^{pj+q'} \right)\right)$$

$$= Tr(B\alpha^{m+r})$$

Ceci démontre par récurrence que l'on a aussi $z_{p,q}^{(0)} = Tr(B\alpha^{pj+q})$ pour p=m/j et $0 \leq q \leq j-1$.

Une fois que les registres $R_q$ ont été initialisés, on procède à m/j-1 cycles de décalage successifs dans les registres $R_q$ (SLB=0). Supposons que l'on ait lors du cycle k-1 : $z_{p,q}^{(k-1)} = Tr(B\alpha^{(p+k-1)j+q})$ pour $0 \leq p \leq m/j$ et $0 \leq q \leq j-1$ (on a vu que ceci était vrai pour k-1=0), On a alors, pour $0 \leq p \leq m/j-1$ et $0 \leq q \leq j-1$ :

$$z_{p,q}^{(k)} = z_{p+1,q}^{(k-1)} = Tr(B\alpha^{(p+k)j+q}) \ ,$$

et d'autre part :

$$z_{m/j,0}^{(k)} = x'_0^{(k)} = \sum_{p=0}^{m/j-1} \sum_{q=0}^{j-1} f_{pj+q} \ Tr(B\alpha^{(p+k)j+q})$$

$$= Tr(B\alpha^{kj} \sum_{i=0}^{m-1} f_i \alpha^i) = Tr(B\alpha^{m+kj+0})$$

Le même raisonnement par récurrence que ci-dessus montre alors que, pour $0 \leq q \leq j-1$, $z_{m/j,q}^{(k)} = Tr(B\alpha^{m+kj+q})$.

Par conséquent, lors de chaque cycle d'horloge k (k=0,1,...), on a $z_{p,q}^{(k)} = Tr(B\alpha^{(p+k)j+q})$ pour $0 \leq p \leq m/j$ et $0 \leq q \leq j-1$.

Revenant à la figure 2, la cellule $30_{p,q}$ comporte j portes ET $34_{p,q,0}, 34_{p,q,1}, ..., 34_{p,q,j-1}$. Pour $0 \leq r \leq q$, la porte ET $34_{p,q,r}$ a une entrée reliée à la sortie de la bascule $M_{p,q}$, une entrée recevant le bit $a_{pj+q-r}$ préalablement chargé dans un registre non représenté, et une sortie délivrant un bit $y_{p,q,r}$. Pour $q+1 \leq r \leq j-1$, la porte ET $34_{p,q,r}$ a une entrée reliée à la seconde entrée (SLB=0) du multiplexeur $33_{p,q}$, une entrée recevant le bit $a_{(p+1)j+q-r}$, et une sortie délivrant un bit $-y_{p,q,r}$. Les bits $y_{p,q,0}, y_{p,q,1}, ..., y_{p,q,j-1}$ forment un j-uplet ou vecteur de j bits $Y_{p,q}$ fourni par la cellule $30_{p,q}$.

Comme le montre la figure 1, une logique combinatoire 36 formant j additionneurs en parallèle fait la somme des vecteurs $y_{p,q}$ ($0 \leq p \leq m/j-1$, $0 \leq q \leq j-1$) pour délivrer un vecteur de sortie de j bits $Y'=\{y'_0, y'_1, ..., y'_{j-1}\}$. La logique 36 consiste simplement en un groupement de portes OU exclusif, l'additionneur de rang r ($0 \leq r \leq j-1$) réalisant l'addition binaire :

$$y'_r = \sum_{p=0}^{m/j-1} \sum_{q=0}^{j-1} y_{p,q,r}$$

Ce bit $y'_r$ est adressé à une sortie $W_r$ du circuit multiplieur. Lors du cycle de décalage k, sa valeur est :

$$y'_r^{(k)} = \sum_{p=0}^{m/j-1} \left( \sum_{q=0}^{r-1} a_{(p+1)j+q-r} Tr(B\alpha^{(p+1+k)j+q}) + \sum_{q=r}^{j-1} a_{pj+q-r} Tr(B\alpha^{(p+k)j+q}) \right)$$

$$= Tr \left( B\alpha^{kj+r} \sum_{p=0}^{m/j-1} \left( \sum_{q'=j-r}^{j-1} a_{pj+q'} \alpha^{pj+q'} + \sum_{q'=0}^{j-r-1} a_{pj+q'} \alpha^{pj+q'} \right) \right)$$

$$= Tr(B\alpha^{kj+r} A) = Tr(C\alpha^{kj+r})$$

$$= c'_{kj+r}$$

En conséquence, le circuit multiplieur délivre en mode mixte série/parallèle les coordonnées en base duale du produit C=AB, et ce seulement en m/j cycles d'horloge : un cycle pour le chargement en parallèle des coordonnées des opérandes A et B dans leurs registres respectifs, et m/j-1 cycles de décalage dans les registres $R_q$.

On observe que si on étend l'architecture du multiplieur qui vient d'être décrite au cas où j=1, alors on retrouve la structure traditionnelle du multiplieur en base duale délivrant un bit par cycle d'horloge.

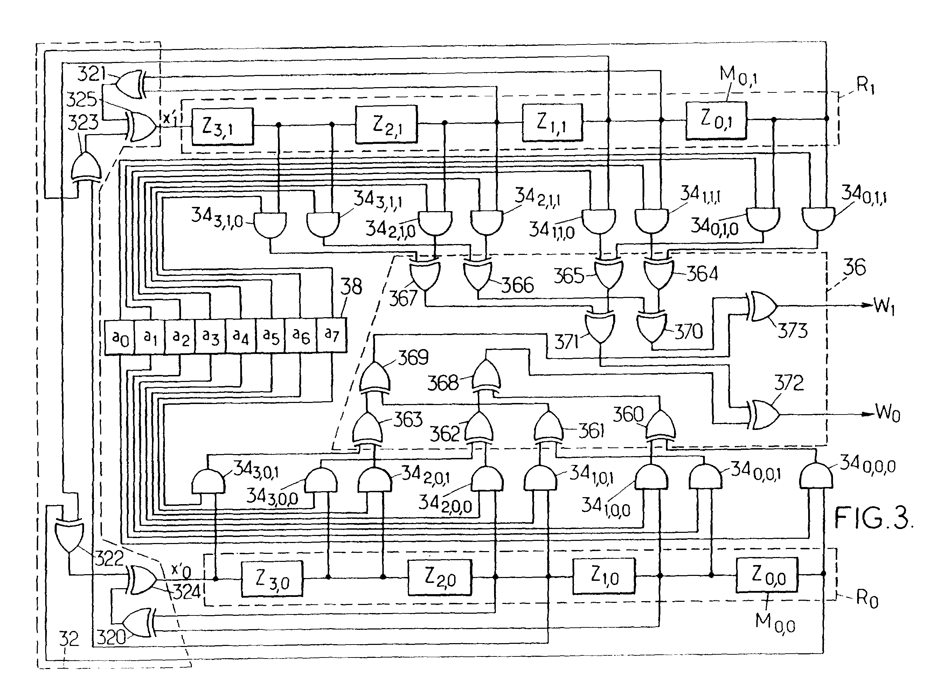

La figure 3 montre un cas particulier de circuit multiplieur selon l'invention, dans le cas m=8, j=2. Le corps de Galois CG($2^8$) est ici construit à partir du polynôme générateur f(x)=$x^8+x^4+x^3+x^2+1$, admettant $\alpha=(02)_{Hex}$ comme élément primitif, l'indice Hex faisant référence à une notation hexadécimale. La base duale de la base standard $\{1,\alpha,\alpha^2,...,\alpha^7\}$ est $\{\beta_0,...,\beta_7\}=\{(AD)_{Hex}(D8)_{Hex}, (C1)_{Hex}, (43)_{Hex}(02)_{Hex}(01)_{Hex}(8E)_{Hex}, (47)_{Hex}\}$.

Les références $R_q, z_{p,q}, x'_r, 32, 34_{p,q,r}, 36, W_r$ utilisées sur les figures 1 et 2 ont été reprises sur la figure 3 avec $0 \leq p \leq m/j-1=3$, $0 \leq q, r \leq j-1=1$ pour désigner des éléments analogues, les multiplexeurs de chargement $33_{p,q}$ n'étant pas représentés pour faciliter la lecture de la figure 3. Les coordonnées en base standard $a_i$ de l'opérande A sont stockées dans un registre parallèle de 8 bits 38. Avec le polynôme générateur choisi, la logique combinatoire 32 se compose de six portes OU exclusif à deux entrées 320-325, organisées en deux étages, le premier étage comportant quatre portes 320-323, et le second étage deux portes 324, 325. Les portes 320, 322, 324 réalisent l'addition binaire $x'_0=z_{0,0}+z_{1,0}+z_{2,0}+z_{1,1}$, tandis que les portes 321, 323, 325 réalisent l'addition binaire $x'_1=z_{2,0}+z_{0,1}+z_{1,1}+z_{2,1}$. En d'autres termes, l'additionneur binaire de rang r=0 ou 1 de la logique 32, dont la sortie est reliée à l'entrée série du registre $R_r$, a trois entrées respectivement reliées aux sorties des éléments de mémorisation $M_{p,q}$ avec $0 \leq p \leq m/j-1=3$, $r \leq q \leq j-1=1$ et $f_{2p+q-r}=1$ et aux entrées des éléments de mémorisation $M_{p,q}$ avec $0 \leq p \leq 3$, $0 \leq q \leq r-1$ et $f_{2(p+1)+q-r}=1$.

La logique combinatoire 36 reliant les portes ET $34_{p,q,r}$ aux sorties $S_0, S_1$ du circuit multiplieur se compose de quatorze portes OU exclusif 360-373 organisées en trois étages, le premier étage comportant huit portes 360-367, le second quatre portes 368-371, et le troisième deux portes 372,373. Les portes 360, 362, 365, 367, 368, 371 et 372 réalisent l'addition binaire $y'_0=y_{0,0,0}+y_{1,0,0}+y_{2,0,0}+y_{3,0,0}+y_{0,1,0}+y_{1,1,0}+y_{2,1,0}+y_{3,1,0}$, tandis que les portes 361, 363, 364, 366, 369, 370 et 373 réalisent l'addition binaire $y'_1=Y_{0,0,1}+y_{1,0,1}+y_{2,0,1}+y_{3,0,1}+y_{0,1,1}+y_{1,1,1}+y_{2,1,1}+y_{3,1,1}$.

Ce circuit effectue une multiplication en m/j=4 cycles d'horloge au lieu de m=8 pour un multiplieur en base duale traditionel. La complexité additionnelle qu'implique cet accroissement de la vitesse reste très limitée : dans une réalisation à base de portes à deux entrées, seulement sept portes ET et dix portes OU exclusif additionnelles sont requises dans l'exemple décrit, ce qui ne représente qu'environ 15% de la surface de silicium du circuit.

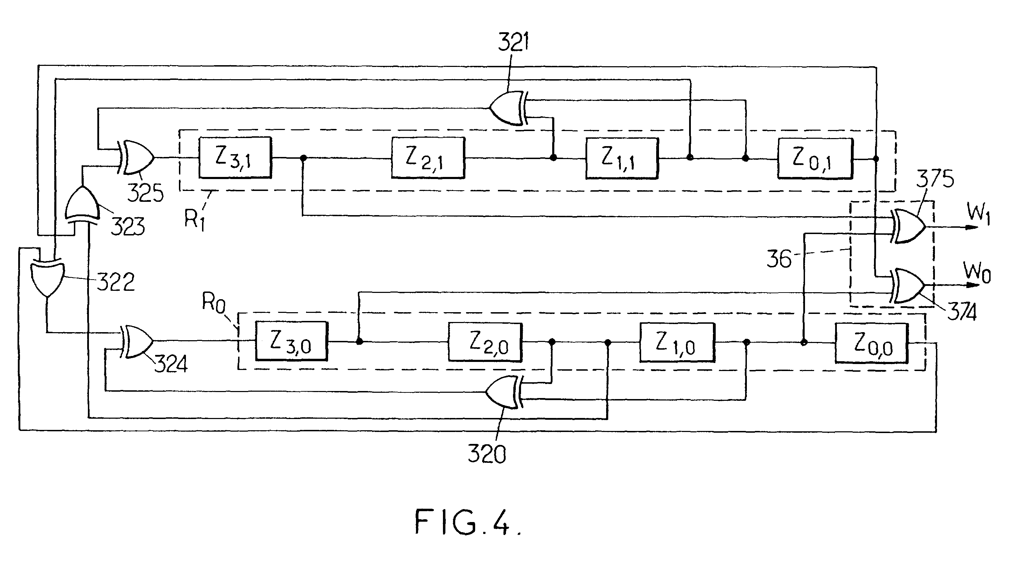

Lorsque l'opérande A exprimé en base standard est fixe, le circuit multiplieur peut être simplifié. Le registre 38 et les mj portes ET $34_{p,q,r}$ ne sont plus nécessaires, et la logique combinatoire 36 requiert généralement un moindre nombre de portes OU exclusif. Chacun des j additionneurs binaires de la logique 36 dont la sortie constitue une des sorties $W_r$ du circuit a alors ses entrées reliées aux sorties des éléments de mémorisation $M_{p,q}$ avec $0 \leq p \leq m/j-1$, $r \leq q \leq j-1$ et $a_{pj+q-r}=1$, et aux entrées des éléments de mémorisation $M_{p,q}$ avec $0 \leq p \leq m/j-1$, $0 \leq q \leq r-1$ et $a_{(p+1)j+q-r}=1$. La figure 4 montre ainsi, dans le cas m=8, j=2, un circuit effectuant en m/j=4 cycles d'horloge la multiplication d'un opérande quelconque B exprimé dans la base duale par un opérande fixe $A=(42)_{Hex}$. Les références de la figure 3 sont reprises sur la figure 4 pour désigner des éléments identiques. Dans ce cas particulier, la logique combinatoire 36 se compose de seulement deux portes OU exclusif 374, 375 réalisant respectivement les opérations $y'_0=y_{0,1,0}+y_{3,0,0}=z_{0,1}+z_{3,0}$ et $y'_1=y_{0,0,1}+y_{3,1,1}=z_{1,0}+z_{3,1}$.

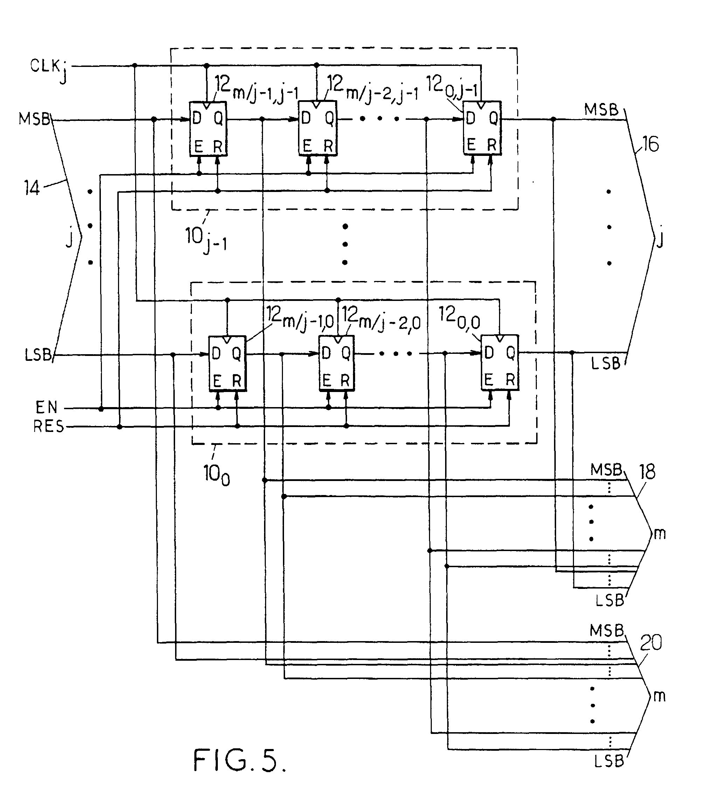

La figure 5 montre la structure d'un registre de m bits adapté à une architecture VLSI utilisant un ou plusieurs circuits multiplieurs du type décrit en référence aux figures 1 à 4. Comme le multiplieur, ce registre a des entrées/sorties parallèles sur j bits ou sur m bits. Sur le schéma de principe de la figure 5, le registre se compose de j registres à décalage $10_0,..., 10_{j-1}$. Chaque registre à décalage $10_q$ se compose de m/j bascules D $12_{0,q},...,12_{m/j-1,q}$ montées en série de façon que l'entrée D d'une bascule $12_{p,q}$ (p<m/j-1) soit reliée à la sortie Q de la bascule $12_{p+1,q}$. L'entrée parallèle sur j bits 14 du registre correspond aux j entrées D des bascules $12_{m/j-1,q}$, le bit de poids le plus faible (LSB) étant adressé à l'entrée D de la bascule $12_{m/j-1,0}$, et le bit de poids le plus fort (MSB) à l'entrée D de la bascule $12_{m/j-1,j-1}$. Les sorties Q des bascules $12_{0,q}$ forment une sortie parallèle sur j bits 16 du registre, le bit de poids le plus faible étant délivré par la bascule $12_{0,0}$, et le bit de poids le plus fort par la bascule $12_{0,j-1}$. Chaque bascule D $12_{p,q}$ est cadencée par un signal d'horloge CLKj qui est le même que celui qui procure les cycles de décalage dans les circuits multiplieurs précédemment décrits. Chaque bascule D a en outre une entrée de validation E (enable) qui autorise les décalages dans les registres $10_q$ sur chaque front montant de l'horloge $CLK_j$ lorsque le signal de validation EN présent sur cette entrée E est au niveau logique 1, et une entrée de réinitialisation R (reset) qui met à zéro le contenu de la bascule sur chaque front montant de l'horloge $CLK_j$ lorsque le signal de réinitialisation RES présent sur cette entrée R est au niveau logique 1. Le registre représenté sur la figure 5 a deux sorties parallèles sur m bits 18, 20, qui seront ci-après appelées respectivement sortie de type 1 et sortie de type 2. Le bit de poids pj+q fourni sur la sortie 18 de type 1 est celui présent sur la sortie Q de la bascule $12_{p,q}$. Le bit de poids pj+q fourni sur la sortie 20 de type 2 est celui présent à l'entrée D de la bascule $12_{p,q}$.

Selon les cas d'utilisation d'un registre de m bits selon la figure 5, on pourra avoir besoin d'un ou plusieurs des trois types de sorties 16, 18, 20, de sorte qu'une ou deux de ces sorties peuvent ne pas être câblées. On note que lorsque seule la sortie parallèle 20 de type 2 est nécessaire, on peut se dispenser des bascules $12_{0,0}, 12_{0,1}, ...,$ $12_{0,j-1}$.

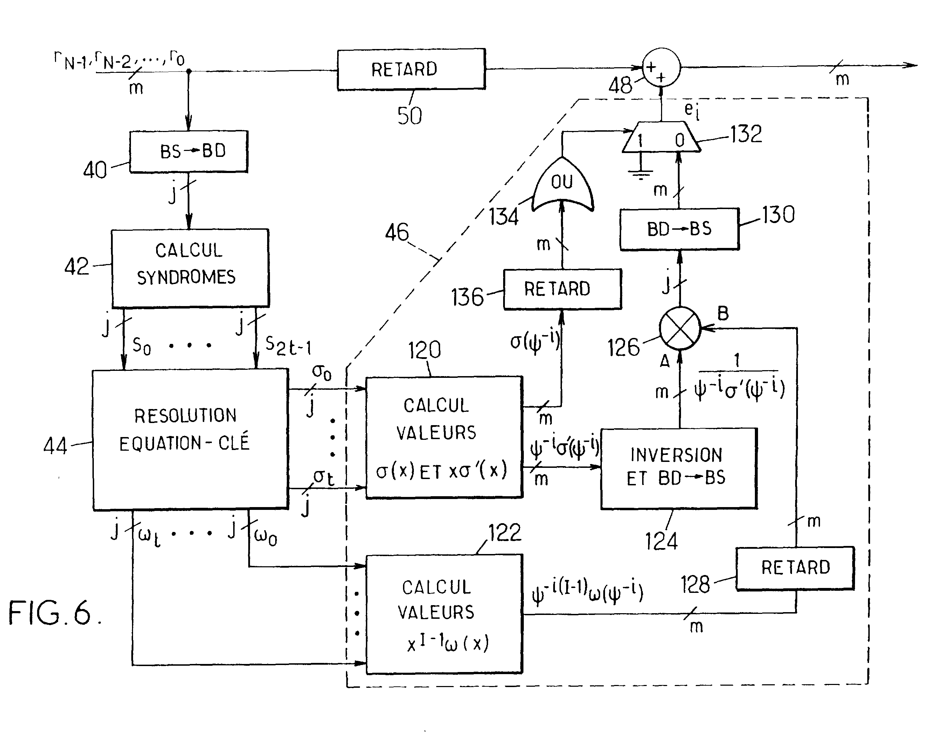

La figure 6 est un schéma synoptique général d'un décodeur Reed-Solomon incorporant l'invention. Les symboles du signal reçu parviennent sur une entrée parallèle sur m bits du décodeur. On suppose que les symboles de chaque bloc sont reçus dans l'ordre $r_{N-1}, r_{N-2}, ..., r_1, r_0$, chaque symbole étant exprimé par ses m coordonnées binaires dans la base standard $\{1, \alpha, ..., \alpha^{m-1}\}$. Un circuit de conversion 40 reçoit les m-uplets de coordonnées binaires des symboles successifs et les transforme pour délivrer les coordonnées en base duale des symboles. Pour chaque symbole, les coordonnées en base duale sont délivrées en m/j groupes successifs de j coordonnées binaires de poids croissants, un groupe étant produit à chaque cycle de l'horloge $CLK_j$. Le circuit 40 peut consister simplement en un registre dans lequel les coordonnées en base standard des symboles successifs sont écrits au rythme de l'horloge symbole $CLK_m$, et en des portes logiques agencées pour délivrer un groupe de j coordonnées en base duale à chaque cycle de l'horloge $CLK_j$ (qui est m/j fois plus rapide que l'horloge symbole $CLK_m$), en tenant compte des relations entre les bases $\{1, \alpha, ..., \alpha^{m-1}\}$ et $\{\beta_0, \beta_1, ..., \beta_{m-1}\}$.

Dans l'exemple précédemment évoqué où m=8, j=2, $f(x)=x^8+x^4+x^3+x^2+1$ et $\alpha=(02)_{Hex}$, les coordonnées en base duale $(a'_0, ..., a'_7)$ d'un élément A du corps de Galois ayant les coordonnées $(a_0, ..., a_7)$ en base standard, sont délivrées par le circuit de conversion 40 en m/j=4 cycles de l'horloge $CLK_j$ de la manière suivante : $a'_0=a_5$ et $a'_1=a_4$ lors du premier cycle, $a'_2=a_3+a_7$ et $a'_3=a_2+a_6+a_7$ lors du second cycle, $a'_4=a_1+a_5+a_6+a_7$ et $a'_5=a_0+a_4+a_5+a_6$ lors du troisième cycle, et $a'_6=a_3+a_4+a_5$ et $a'_7=a_2+a_3+a_4$ lors du quatrième cycle.

Un module 42 calcule les 2t syndromes $S_0, ..., S_{2t-1}$ sur la base des coordonnées en base duale des symboles reçus, fournies par le circuit de conversion 40. Ces syndromes sont ensuite traités par un circuit 44 de résolution de l'équation-clé qui fournit les coefficients $\sigma_0, ..., \sigma_t$ et $\omega_0, ..., \omega_t$ du polynôme localisateur d'erreurs $\sigma(x)$ et du polynôme évaluateur d'erreurs $\omega(x)$. Un module de calcul de correction 46 détermine les amplitudes $e_i$ des erreurs dans l'ordre i=N-1, N-2, ..., 1, 0, ces amplitudes $e_i$ étant ajoutées aux symboles correspondants $r_i$ par l'additionneur parallèle sur m bits 48. Pour tenir compte du temps mis par les modules 40, 42, 44, 46 pour produire les amplitudes $e_i$, un circuit 50, pouvant consister en une mémoire premier entré-premier sorti (FIFO), retarde les symboles $r_i$ à l'entrée de l'additionneur 48 d'un nombre approprié de cycles de l'horloge symbole $CLK_m$.

Les signaux d'horloge $CLK_j$ et $CLK_m$, ainsi que les différents signaux de commande décrits ci-après sont fournis, par une base de temps non représentée du décodeur.

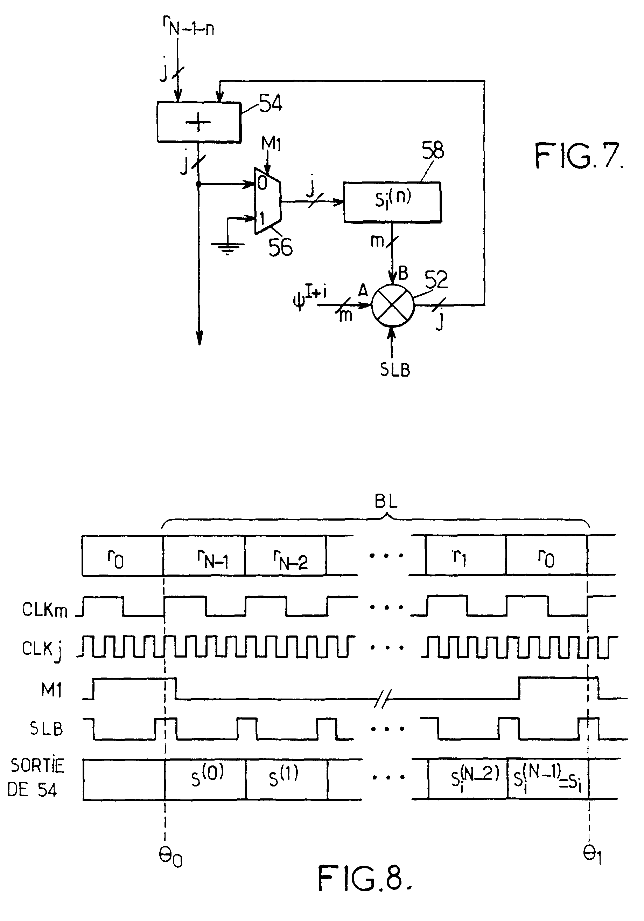

Le module 42 se compose de 2t circuits de calcul de syndrome tels que celui représenté sur la figure 7 pour le calcul d'un syndrome $S_i=R(\psi^{l+i})$ ($0 \leq i \leq 2t-1$). Le circuit de la figure 7 comporte un multiplieur en base duale 52 dont l'opérande A exprimé en base standard est fixe, égal à $\psi^{l+i}$, et un additionneur parallèle sur j bits 54 dont une première entrée sur j bits reçoit un groupe de j coordonnées binaires d'un symbole $r_{N-1-n}$ et une autre entrée sur j bits est reliée aux sorties $W_0, ..., W_{j-1}$ du multiplieur 52. L'additionneur 54 réalise la somme du bit délivré par chaque sortie $W_q$ du multiplieur avec le bit de poids q reçu sur sa première entrée. Pour fournir au multiplieur 52 son opérande B exprimé en base duale, le circuit comporte un multiplexeur 56 commandé par un signal binaire M1 et un registre 58. Le registre 58 est du type décrit en référence à la figure 5, avec une entrée parallèle sur j bits et seulement une sortie parallèle sur m bits de type 2.

Le fonctionnement du circuit de calcul de syndrome de la figure 7 est illustré par les chronogrammes de la figure 8. La première ligne illustre l'arrivée des symboles successifs $r_{N-1}, r_{N-2}, ..., r_1, r_0$ d'un bloc BL au rythme de l'horloge symbole $CLK_m$. Le signal de commande M1 a la périodicité des blocs. Il présente une impulsion de niveau logique 1 de durée égale à une période de l'horloge symbole $CLK_m$ lors de l'arrivée du dernier symbole de chaque bloc. Lorsque M1=1, le multiplexeur 56 adresse à l'entrée parallèle du registre 58 j bits égaux à 0. Lorsque M1=0, le multiplexeur 56 adresse à l'entrée parallèle du registre 58 les j bits délivrés par l'additionneur 54. Le signal SLB de chargement de l'opérande B dans le multiplieur 52 a la périodicité des symboles. Il présente des impulsions de niveau 1 et de durée égale à une période de l'horloge $CLK_j$, de façon que chaque front montant de l'horloge $CLK_m$ survienne lorsque SLB=1. Ainsi, un opérande B=0 est chargé dans le multiplieur 52 pour une étape n=0 correspondant à l'arrivée du premier symbole $r_{N-1+n}=r_{N-1}$ de chaque bloc, et l'opérande B chargé dans le multiplieur 52 au début de l'étape suivante n=1 (chaque étape dure un cycle de l'horloge $CLK_m$) est $B=S_i^{(0)}=r_{N-1}$. Au cours de chaque étape n ($0 \leq n \leq N-1$), le symbole $r_{N-1+n}$ parvient à l'additionneur 54, et la quantité $S_i^{(n)}$ (cf. relation (5) ci-dessus) est délivrée par l'additionneur 54. Cette quantité $S_i^{(n)}$ est chargée comme opérande B dans le multiplieur 52 au début de l'étape suivante n+1 (sauf pour n=N-1). Lors de la dernière étape n=N-1, l'additionneur 54 délivre, en m/j groupes de j coordonnées binaires en base duale, la valeur du syndrome $S_i=S_i^{(N-1)}$, comme illustré par la dernière ligne de la figure 8.

On voit que le syndrome $S_i$ est disponible en sortie du multiplieur 54 dès l'arrivée du dernier symbole $r_0$ du bloc, à un instant noté $\theta_1$. Si $\theta_0$ désigne l'instant où parvient le premier symbole $r_{N-1}$ du bloc, le temps d'attente $\theta_1 - \theta_0$ correspond à la plus petite valeur possible, à savoir la périodicité des blocs.

L'utilisation du multiplieur en base duale avec $j \geq 2$ à l'avantage de permettre, pour une fréquence donnée $f_j$ de l'horloge $CLK_j$, de traiter un débit d'entrée correspondant à une fréquence de symboles de $(j/m)f_j$, c'est-à-dire à une fréquence de symboles j fois plus élevée qu'avec les multiplieurs traditionnels (j=1). Exprimé autrement, si on se fixe une fréquence de symboles $f_m$, le multiplieur en base duale avec j≥2 permet de calculer les syndromes, avec un temps d'attente minimal, en utilisant dans le circuit VLSI une horloge $CLK_j$ de fréquence j fois plus faible que celle nécessaire avec les multiplieurs traditionnels. Ceci réduit considérablement les contraintes technologiques imposées à la conception d'un décodeur Reed-Solomon.

Dans le cas fréquent où ψ=α et l=0, les racines $\psi^{l+i}$ du polynôme générateur du code dont des petites puissances de α, et la plupart d'entre elles ont un petit nombre de coordonnées non nulles en base standard. En conséquence, les multiplieurs 52 des circuits de calcul de syndrome ont des structures simplifiées, de sorte que la complexité supplémentaire qu'implique le cas j≥2 (typiquement j=2) reste très faible. Ce cas est notamment rencontré dans les normes DVB retenues pour le codage canal dans le domaine de la télévision numérique, avec m=8, t=8, N=204.

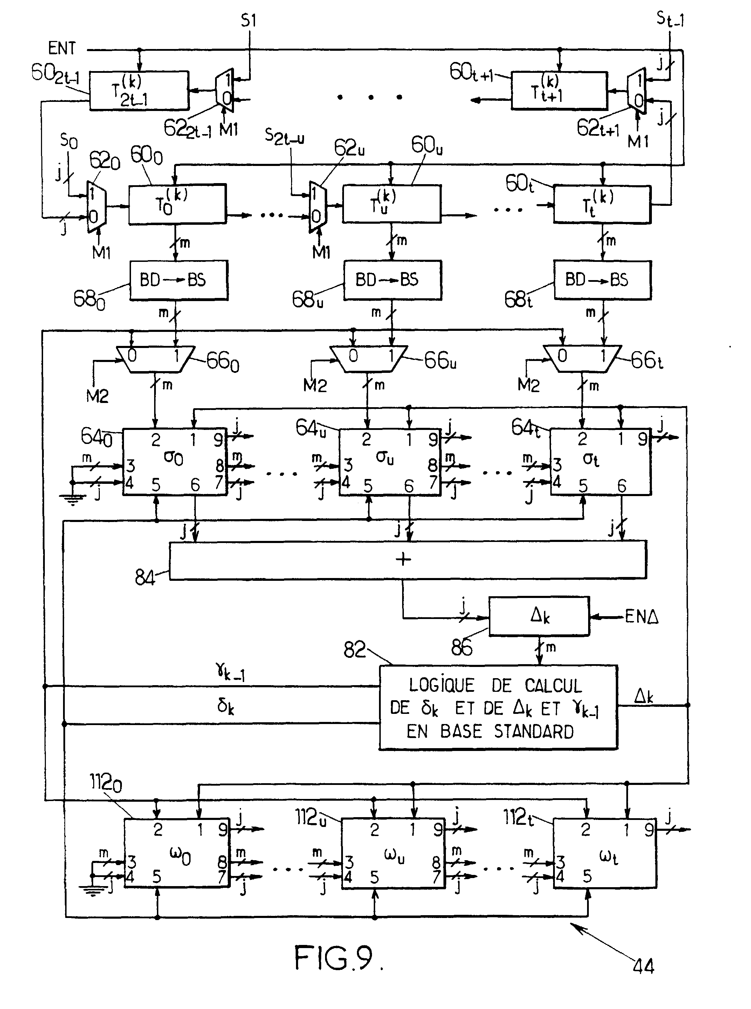

La figure 9 montre l'architecture du circuit 44 de résolution de l'équation-clé du décodeur de la figure 6. Le circuit 44 comporte 2t registres de m bits $60_0,...,60_u,...,60_{2t-1}$ cadencés par l'horloge $CLK_j$ et recevant un signal ENT comme signal de validation. Chacun de ces 2t registres $60_u$ est du type décrit en référence à la figure 5 avec une entrée parallèle sur j bits, une sortie parallèle sur j bits et une sortie parallèle sur m bits de type 1. Chaque registre $60_u$ est associé à un multiplexeur respectif $62_u$ commandé par le signal M1. Le multiplexeur $62_u$ (1≤u≤2t-1) relie l'entrée parallèle sur j bits du registre $60_u$ à la sortie parallèle sur j bits du registre $60_{u-1}$ lorsque M1=0, et à la sortie de l'additionneur 54 du circuit de calcul du syndrome $S_{2t-u}$ lorsque M1=1. Le multiplexeur 60 relie l'entrée parallèle sur j bits du registre $60_0$ à la sortie parallèle sur j bits du registre $60_{2t-1}$ lorsque M1=0, et à la sortie de l'additionneur 54 du circuit de calcul du syndrome $S_0$ lorsque M1=1. Comme les additionneurs 54 délivrent les syndromes pendant que M1=1 (figure 8), ces syndromes se trouvent chargés dans les registres $60_u$ quand M1=1, et quand M1=0, les valeurs des syndromes tournent dans les registres $60_u$ qui sont connectés en boucle.

Pour chaque coefficient $\sigma_u$ (0≤u≤t) du polynôme localisateur d'erreurs σ(x), le circuit 44 comporte respectivement une cellule de calcul $64_u$, un multiplexeur $66_u$ commandé par un signal M2, et un circuit de conversion $68_u$. Chaque circuit de conversion $68_u$ est un agencement de portes logiques qui reçoit les m coordonnées binaires en base duale présentes sur la sortie parallèle sur m bits du registre $60_u$, représentant un syndrome, et les convertit pour fournir les m coordonnées binaires en base standard de ce syndrome, en tenant compte des relations entre les bases {$\beta_0$, $\beta_1,...,\beta_{m-1}$} et {1,α, ...,$\alpha^{m-1}$}.

Dans l'exemple précédemment évoqué où m=8, j=2, $f(x)=x^8+x^4+x^3+x^2+1$ et $\alpha=(02)_{Hex}$, les coordonnées en base standard ($b_0,...,b_7$) d'un élément B du corps de Galois ayant les coordonnées ($b'_0,...,b'_7$) en base duale sont délivrées par le circuit de conversion $60_u$ de la manière suivante : $b_0 = b'_0+b'_2+b'_3+b'_5+b'_7$, $b_1 = b'_3+b'_4+b'_6+b'_7$, $b_2 = b'_0+b'_6+b'_7$, $b_3 = b'_0+b'_1+b'_6$, $b_4 = b'_1$, $b_5 = b'_0$, $b_6 = b'_1+b'_2+b'_3+b'_7$, et $b_7 = b'_0+b'_1+b'_2+b'_6$.

Dans l'exemple représenté sur les figures 9 à 11, le circuit de résolution d'équation-clé est agencé pour fonctionner selon la variante de l'algorithme de Berlekamp-Massey décrite dans l'article précité de I.S. Reed et al. Cet algorithme procède en 2t itérations successives k=1,...,2t. et fait appel à un paramètre $\gamma_{k-1}$ du corps de Galois permettant de se dispenser des calculs d'inverses nécessaires dans les versions traditionnelles de l'algorithme de Berlekamp-Massey (cf. relation (7.5)). L'algorithme de Reed et al peut s'exprimer de la manière suivante :

Initialisation : $\sigma^{(0)}(x)=1$, $\lambda^{(0)}(x)=1$, $L_0=0$, $\gamma_0=1$, $\omega^{(0)}(x)=1$, $\mu^{(0)}(x)=0$.

Pour chaque itération k :

$$\Delta_k = \sum_{u=0}^{t} \sigma_u^{(k-1)} S_{k-u-1} \qquad\qquad \textbf{(14.1)}$$

$$\delta_k = \begin{cases} 0 \text{ si } \Delta_k=0 \text{ ou } 2L_{k-1}>k-1 \\ 1 \text{ si } \Delta_k\neq0 \text{ et } 2L_{k-1}\leq k-1 \end{cases} \qquad (14.2)$$

$$\sigma^{(k)}(x) = \gamma_{k-1}\,\sigma^{(k-1)}(x)+\Delta_k x.\lambda^{(k-1)}(x) \qquad\qquad (14.3)$$

$$\lambda^{(k)}(x) = \delta_k\,\sigma^{(k-1)}(x) + (1-\delta_k)\lambda^{(k-1)}(x) \qquad\qquad (14.4)$$

$$\omega^{(k)}(x) = \gamma_{k-1}\ \omega^{(k-1)}(x) + \Delta_k x.\mu^{(k-1)}(x) \qquad (14.5)$$

$$\mu^{(k)}(x) = \delta_k\ \omega^{(k-1)}(x) + (1-\delta_k)\mu^{(k-1)}(x) \qquad (14.6)$$

$$L_k = \delta_k(k-L_{k-1}) + (1-\delta_k)L_{k-1} \qquad (14.7)$$

$$\gamma_k = \delta_k\ \Delta_k + (1-\delta_k)\ \gamma_{k-1} \qquad (14.8)$$

Le polynôme localisateur d'erreurs et le polynôme évaluateur d'erreurs sont obtenus au terme des 2t itérations : $\sigma(x) = \sigma^{(2t)}(x)$ et $\omega(x) = \omega^{(2t)}(x)$ avec :

$$\kappa = \prod_{k=1}^{2t}\ \gamma_{k-1}$$

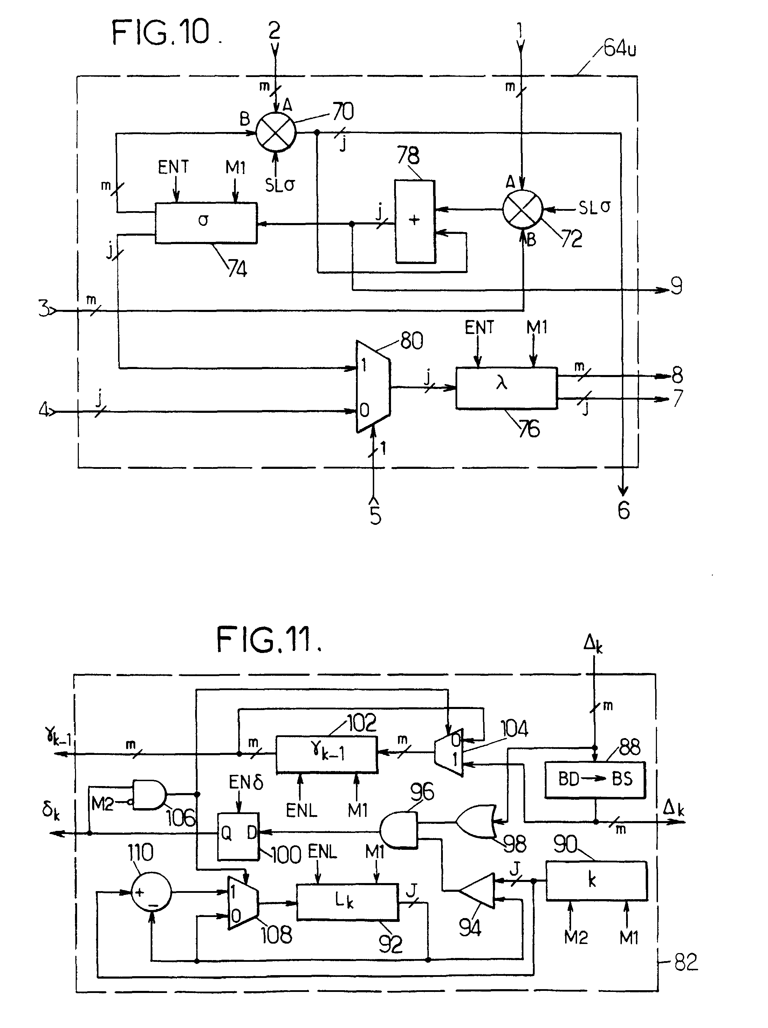

En référence aux figures 9 et 10, chaque cellule $64_u$ ($0 \le u \le t$) comporte cinq entrées 1-5 et quatre sorties 6-9. Les entrées 1 à 3 sont des entrées parallèles sur m bits, l'entrée 4 est une entrée parallèle sur j bits, et l'entrée 5 est une entrée binaire. Les sorties 6, 7 et 9 sont des sorties parallèles sur j bits et la sortie 8 est une sortie parallèle sur m bits. Chaque cellule $64_u$ comprend deux multiplieurs en base duale 70, 72 et deux registres de m bits 74, 76 qui sont des registres du type décrit en référence à la figure 5 ayant chacun une entrée parallèle sur j bits, une sortie parallèle sur j bits, et une sortie parallèle sur m bits de type 1. Ces deux registres 74, 76 reçoivent le signal M1 comme signal de réinitialisation et le signal ENT comme signal de validation. L'opérande A en base standard du multiplieur 72 correspond aux m bits présents sur l'entrée 1 de la cellule. L'opérande A en base standard du multiplieur 70 correspond aux m bits présents sur l'entrée 2 de la cellule. L'opérande B en base duale du multiplieur 70 est lu dans le registre 74 par sa sortie parallèle sur m bits. Chaque cellule $64_u$ comprend en outre un additionneur parallèle sur j bits 78 qui reçoit sur une entrée les j bits délivrés par le multiplieur 70 et sur l'autre entrée les j bits délivrés par le multiplieur 72. La sortie sur j bits de l'additionneur 78 est reliée à l'entrée parallèle sur j bits du registre 74. Chaque cellule $64_u$ comprend encore un multiplexeur 80 commandé par le bit reçu sur l'entrée binaire 5, ce bit étant égal à $\delta_k$ lors de l'itération k. Le multiplexeur 80 relie l'entrée parallèle sur j bits du registre 76 à la sortie parallèle sur j bits du registre 74 lorsque $\delta_k=1$, et à l'entrée 4 de la cellule lorsque $\delta_k=0$. La sortie parallèle sur j bits du registre 76 constitue la sortie 7 de la cellule $64_u$ qui est reliée à l'entrée 4 de la cellule $64_{u+1}$ pour $0 \le u < t$. La sortie parallèle sur m bits du registre 76 constitue la sortie 8 de la cellule $64_u$ qui est reliée à l'entrée 3 de la cellule $64_{u+1}$ pour $0 \le u < t$. Les entrées 3 et 4 de la cellule $64_0$ reçoivent des bits de niveau 0. L'opérande B en base duale du multiplieur 72 correspond aux m bits présents sur l'entrée 3 de la cellule. La sortie 9 de la cellule est constituée par la sortie de son additionneur 78.

Une logique de calcul 82 qui sera décrite ci-après fournit lors de chaque itération k les valeurs des paramètres $\gamma_{k-1}$ et $\Delta_k$ du corps de Galois (exprimées en base standard) et du paramètre binaire $\delta_k$ utiles à la mise à jour des polynômes $\sigma$ et $\lambda$ pour cette itération (relations (14.3) et (14.4)). Les paramètres $\Delta_k$ et $\delta_k$ sont respectivement fournis par la logique 82 sur les entrées 1 et 5 des cellules $64_u$. Le paramètre $\gamma_{k-1}$ est présenté sur une première entrée sur m bits de chacun des multiplexeurs $66_u$. L'autre entrée du multiplexeur $66_u$ reçoit les m bits délivrés par le circuit de conversion $68_u$. La sortie du multiplexeur $66_u$ est reliée à l'entrée 2 de la cellule $64_u$. Les multiplexeurs $66_u$ sont commandés par un signal commun M2 qui sépare chaque itération en deux phases, à savoir une première phase (M2=1 : le syndrome $S_{k-u-1}$ est adressé à l'entrée 2 de la cellule $64_u$) pour le calcul de l'écart de prédiction $\Delta_k$ selon la formule (14.1), et une seconde phase (M2=0 : le paramètre $\gamma_{k-1}$ est adressé à l'entrée 2 de chacune des cellules $64_u$) pour la mise à jour des coefficients selon les formules (14.3) et (14.4).

Lors de chaque itération k, des nouvelles valeurs des coordonnées en base duale des coefficients $\sigma_u^{(k)}$ et $\lambda_u^{(k)}$ sont calculées et stockées dans les registres 74 et 76 de la cellule $64_u$. Pour initialiser les registres 74 et 76 conformément à l'algorithme, le signal de réinitialisation (appelé RES sur la figure 5) fourni aux registres 74 et 76 peut être constitué par le signal M1. Les registres 74 et 76 de la cellule $64_0$ doivent toutefois se réinitialiser à 1 (exprimé en base duale) et non à 0 (dans l'exemple numérique précédemment considéré, $1=\beta_5$ de sorte que ce sont les bascules $12_{2,1}$ des registres 74 et 76 de la cellule $64_0$ qui sont à réinitialiser à 1).

Dans la première phase de chaque itération k, les multiplieurs 70 des cellules $64_u$ fournissent les coordonnées en base duale des quantités $\sigma^{(k-1)}S_{k-u-1}$ en m/j groupes successifs sur les sorties 6. Un additionneur parallèle sur j bits 84 a t+1 entrées respectivement reliées aux sorties 6 des cellules $64_u$. La sortie sur j bits de l'additionneur 84 est reliée à l'entrée parallèle sur j bits d'un registre de m bits 86. Le registre 86 est du type décrit en référence à la figure 5 avec une sortie parallèle sur m bits de type 1. Il reçoit un signal ENΔ comme signal de validation. Ainsi, au terme de la première phase de l'itération k, l'écart de prédiction $\Delta_k$ (relation (14.1)) exprimé en base duale est stocké dans le registre 86.

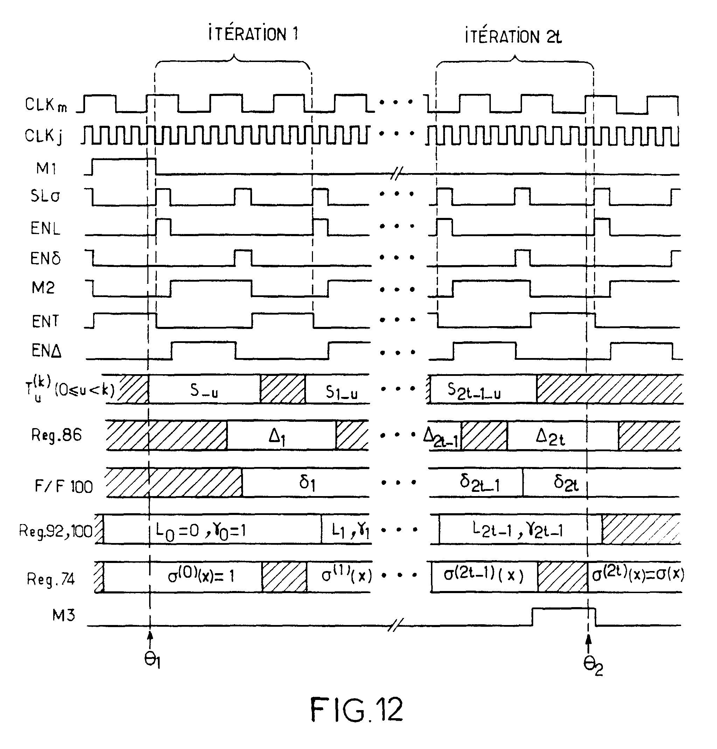

La figure 11 montre un schéma de la logique 82 qui traite les écarts de prédiction $\Delta_k$ calculés dans les premières phases des itérations. Un circuit de conversion 88 identique aux circuits de conversion $68_u$ produit les coordonnées en base standard de l'écart de prédiction $\Delta_k$ dont les coordonnées en base duale sont disponibles dans le registre 86. Les m coordonnées en base standard de $\Delta_k$ ainsi obtenues sont adressées aux entrées 1 des cellules $64_u$. La logique 82 comporte un compteur 90 sur J bits fournissant la valeur du numéro k de l'itération en cours, J étant l'entier égal ou immédiatement supérieur à $\log_2(2t)$. Le compteur 90 est mis à zéro par le signal M1 et incrémenté d'une unité à chaque front montant du signal M2 qui rythme les itérations. Un registre parallèle sur J bits 92 est prévu pour contenir la valeur de la variable entière $L_k$. Ce registre 92 est initialisé à 0 par le signal M1, et il enregistre les bits présents à son entrée sur chaque front montant d'un signal ENL. Un comparateur 94 compare les valeurs de k et $L_k$ présentes dans le compteur 90 et le registre 92 pour délivrer un bit valant 1 si $k>2L_{k-1}$ (c'est-à-dire $2L_{k-1}\leq k-1$) et valant 0 si $k\leq 2L_{k-1}$. Ce bit est adressé à une entrée d'une porte ET 96 dont l'autre entrée est reliée à la sortie d'un circuit OU à m entrées 98. Les m entrées du circuit OU 98 reçoivent les m coordonnées binaires en base duale de l'écart $\Delta_k$ présentes dans le registre 86. Une bascule D 100 cadencée par un signal ENδ est prévue pour stocker la valeur courante du paramètre binaire $\delta_k$. L'entrée D de cette bascule 100 est reliée à la sortie de la porte ET 96, et sa sortie Q est reliée aux entrées 5 des cellules $64_u$. La sortie de la porte ET 96 est à 1 lorsque $\delta_k\neq 0$ et $2L_{k-1}\leq k-1$ et à 0 sinon, de sorte que $\delta_k$ est mis à jour selon les relations (14.2).

La logique 82 comporte un registre parallèle de m bits 102 servant à contenir les coordonnées en base standard du paramètre $\gamma_{k-1}$ lors de l'itération k. La sortie de ce registre 102 est reliée aux premières entrées des multiplexeurs $66_u$, ainsi qu'à une entrée d'un multiplexeur 104 de la logique 82. L'autre entrée de ce multiplexeur 104 est reliée à la sortie du circuit de conversion 88 pour recevoir les m coordonnées en base standard de l'écart $\Delta_k$, et sa sortie est reliée à l'entrée du registre 102. Le registre 102 est initialisé à 1 ($=\alpha^0$ exprimé en base standard) par le signal M1, et il enregistre la valeur fournie par le multiplexeur 104 sur chaque front montant du signal ENL. Le multiplexeur 104 est commandé par le bit de sortie d'une porte ET 106 réalisant l'opération logique ET entre le bit $\delta_k$ présent en sortie de la bascule 100 et le complément du signal M2, de façon qu'on ait $\gamma_k=\Delta_k$ si $\delta_k=1$ et $\gamma_k=\gamma_{k-1}$ si $\delta_k=0$ (relation (14.8)). La porte ET 106 commande un autre multiplexeur 108 alimentant l'entrée du registre 92. Ce multiplexeur 108 a deux entrées sur J bits, l'une reliée à la sortie du registre 92 et l'autre reliée à la sortie d'un soustracteur 110. Le soustracteur 110 a son entrée positive reliée à la sortie du compteur 90 et son entrée négative reliée à la sortie du registre 92, de façon à produire le nombre $k-L_{k-1}$. Le multiplexeur 108 relie l'entrée du registre 92 à la sortie du registre 92 s'il est commandé par un signal de niveau 0 issu de la porte 106, et à la sortie du soustracteur 110 sinon, de sorte qu'on a $L_k=k-L_{k-1}$ lorsque $\delta_k=1$ et $L_k=L_{k-1}$ lorsque $\delta_k=0$ conformément à la relation (14.7).

Pour le calcul du polynôme évaluateur d'erreurs $\omega(x)$, le circuit 44 de résolution de l'équation-clé comporte en outre t+1 cellules de calcul $112_0,...,112_t$ qui sont identiques aux cellules $64_u$ précédemment décrites, à cette seule différence près que le registre 76 de la cellule $112_0$ est initialisé à 0 et non à 1. Les registres 74 et 76 des cellules $112_u$ contiennent respectivement les coordonnées en base duale des coefficients $\omega_u$ et $\mu_u$ polynôme évaluateur $\omega(x)$ et de son polynôme intermédiaire associé $\mu(x)$.

Le cadencement du circuit de résolution d'équation-clé est par exemple conforme aux chronogrammes de la figure 12, établis dans un cas où m/j=4. Chaque itération k correspond à $2(m/j+1)$ cycles de l'horloge $CLK_j$, la première phase et la seconde phase durant chacune m/j+1 cycles de l'horloge $CLK_j$. SLσ désigne le signal fourni aux multiplieurs 70, 72 des cellules pour le chargement de leurs opérandes B respectifs. Ce signal SLσ a une impulsion de niveau 1 durant un cycle de l'horloge $CLK_j$ au début de chaque phase de chaque itération. Le signal M2, de période égale à la durée d'une itération, c'est-à-dire à $2(m/j+1)$ périodes de l'horloge $CLK_j$, présente un front montant une période de $CLK_j$ après le début de la première phase de chaque itération et un front descendant une période de CLKj après le début de la seconde phase de chaque itération. Les signaux de validation ENL, ENδ, ENT et ENΔ correspondent aux résultats des opérations logiques FNL=SLσ $ET\ \overline{M2}$, ENδ=SLσ $ET$ M2, ENT=$\overline{SL\sigma}$ $ET\ \overline{M2}$, et ENΔ=$\overline{SL\sigma}$ $ET$ M2.

Lors de la première phase de chaque itération k ($1\leq k\leq 2t$), les registres $60_u$ ($0\leq u\leq k-1$) contiennent les syndromes $T_u^{(k)}=S_{k-1-u}$. Le premier cycle d'horloge $CLK_j$ de la première phase de chaque itération k est consacré au chargement des opérandes $\sigma_u^{(k-1)}$ en base duale dans les multiplieurs 70 des cellules $64_u$ (SLσ=1), et à la mémorisation des valeurs de $L_{k-1}$ et $\gamma_{k-1}$ dans les registres 92 et 100 (ENL=1) comme indiqué sur la ligne "Reg.92,100" de la figure 12. Le compteur 90 est ensuite incrémenté par le front montant de M2 pour contenir l'index k de l'itération. Lors des m/j derniers cycles de la première phase de l'itération k, la somme des produits $\sigma_u^{(k-1)}S_{k-u-1}$ délivrés par les multiplieurs 70 des cellules $64_u$ est chargée dans le registre 86 (ENΔ=1), l'écart $\Delta_k$ en base duale étant ainsi calculé selon la relation (14.1) (étant noté que $\sigma_u^{(k-1)}=0$ pour $u\geq k$). Le premier cycle de la seconde phase de l'itération k est consacré au chargement des opérandes en base duale $\sigma_u^{(k-1)}$, $\lambda_{u-1}^{(k-1)}$, $\omega_u^{(k-1)}$ et $\mu_u^{(k-1)}$ dans les multiplieurs des cellules $64_u$ et

$112_u$ (SLσ=1) et à la mémorisation de $\delta_k$ dans la bascule 100 (ENδ=1) comme indiqué sur la ligne "F/F 100" de la figure 12. Les paramètres $\gamma_{k-1}$ et $\Delta_k$ restent dans leurs registres respectifs 102, 86 pendant la seconde phase de l'itération k. Lors des m/j derniers cycles de la seconde phase de l'itération k, les registres 74 et 76 des cellules $64_u$, $112_u$ sont chargés avec les bits délivrés par les additionneurs 78 et les multiplexeurs 80 (ENT=1) pour mettre à jour les polynômes σ, λ, ω et μ selon les relations (14.3) à (14.6). En même temps, m/j cycles de décalage sont effectués dans les registres $60_u$ (ENT=1) pour charger les syndromes $T_u^{(k+1)}=S_{k-u}$ utiles à l'itération suivante.

Les coefficients $\sigma_u=\sigma_u^{(2t)}$ et $\omega_u=\omega_u^{(2t)}$ des polynômes localisateur et évaluateur sont délivrés (exprimés en base duale) sur les sorties 9 des cellules $64_u$ et $112_u$ lors des m/j derniers cycles de l'itération 2t. Ces coefficients sont complètement disponibles à un instant désigné par $\theta_2$ sur la figure 12, tel que $\theta_2 - \theta_1$ correspond à 4t(1+m/j) périodes de l'horloge $CLK_j$.

L'architecture du circuit 44 de résolution de l'équation-clé présente une grande régularité du fait de l'utilisation de cellules standardisées $64_u$, $112_u$. Ceci constitue un avantage important dans le cadre d'une implémentation VLSI. Le fait que les multiplieurs 70 des cellules $64_u$ servent à la fois au calcul des écarts de prédiction (première phase) et à la mise à jour des coefficients (seconde phase) grâce aux multiplexeurs $66_u$, permet de réduire le nombre de circuits multiplieurs requis sans diminuer la rapidité du circuit. Le circuit reçoit les syndromes par groupes de j bits depuis le module 42 et délivre également les coefficients $\sigma_u$, $\omega_u$ par groupes de j bits, ce qui convient bien à l'organisation en pipe-line du décodeur.

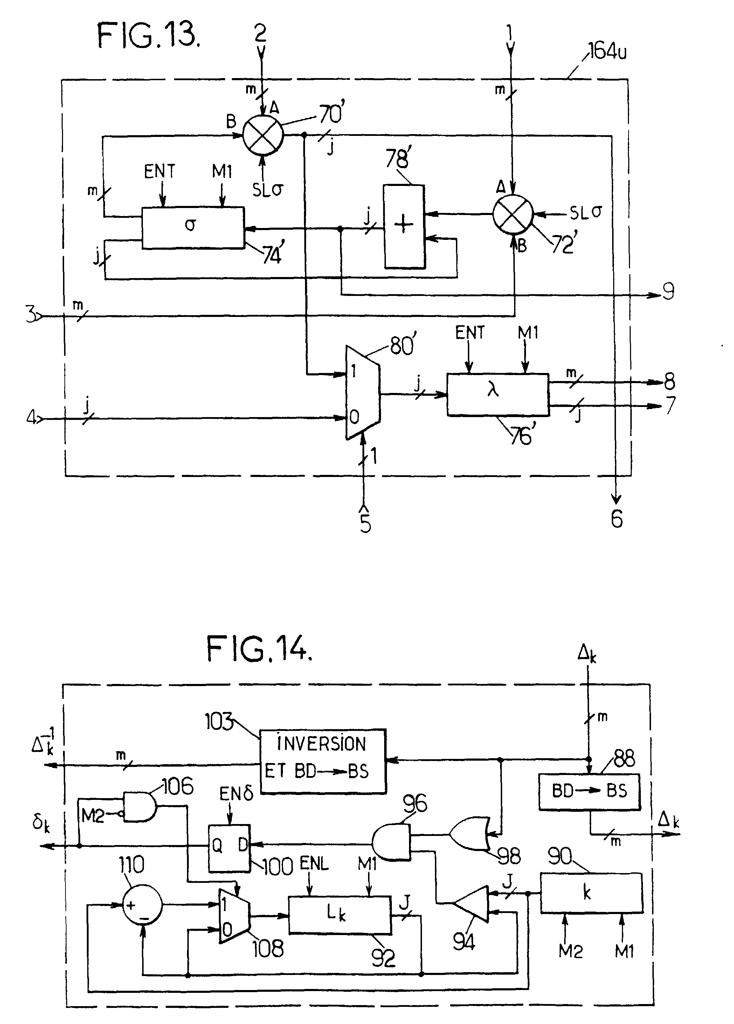

Cette architecture du circuit de résolution d'équation-clé s'adapte aisément aux diverses variantes de l'algorithme de Berlekamp-Massey, et en particulier à la version avantageuse de Reed et al comme décrit ci-dessus. Les figures 13 et 14 illustrent l'architecture adaptée au cas de la version traditionnelle de l'algorithme de Berlekamp-Massey représentée par les formules (7.1) à (7.7). Les cellules $164_u$ selon la figure 13 peuvent remplacer les cellules $64_u$ (et $112_u$) sur la figure 9, tandis que la logique 182 de la figure 14 peut remplacer la logique 82.

La logique 182 a une structure en grande partie identique à la logique 82 montrée sur la figure 11, de sorte que les mêmes références numériques ont été utilisées pour désigner des composants identiques. Le paramètre $\gamma_{k-1}$ est remplacé par l'inverse $\Delta_k^{-1}$ de l'écart de prédiction, produit par un circuit d'inversion 103. Ce circuit 103 est par exemple constitué par un tableau de mémoire ROM de $2^m$ emplacements de m bits. L'adressage dans ce tableau s'effectue par exemple selon une adresse de m bits correspondant aux m bits présents dans le registre 86 et représentant les coordonnées en base duale de $\Delta_k$. A une adresse donnée, le tableau contient l'inverse exprimé en base standard de l'élément du corps de Galois représenté en base duale par les m bits de cette adresse.

La cellule $164_u$ représentée sur la figure 13 est également très semblable à la cellule $64_u$ décrite en référence à la figure 10. Les références numériques 70', 72', 74', 76', 78' et 80' ont été employées sur la figure 13 pour désigner des éléments identiques à 70, 72, 74, 76, 78 et 80 sur la figure 10. La cellule $164_u$ diffère de la cellule $64_u$ en ce que :

- la sortie du multiplieur 70' est reliée à l'entrée ($\delta_k$=1) du multiplexeur 80' et non à l'entrée de l'additionneur 78' ; et
- la sortie parallèle sur j bits du registre 74' est reliée à l'entrée de l'additionneur 78' et non à l'entrée du multiplexeur 80'.

Dans le cas des figures 9, 13 et 14, le cadencement du circuit de résolution d'équation-clé est très semblable à celui des figures 9, 10 et 11. Il peut notamment être conforme aux chronogrammes de la figure 12.

On note qu'il est possible de se dispenser de certains composants des cellules de calcul de $\sigma_0$, $\sigma_t$, $\omega_0$ et $\omega_t$. C'est le cas des multiplieurs 72 (ou 72') des cellules $64_0$ et $112_0$ (ou $164_0$) puisque ceux-ci ont toujours une valeur nulle pour leur opérande B. D'autre part, les cellules $64_0$ et $112_0$ peuvent partager leur multiplieur 70 et leur registre 74 puisque, conformément à l'algorithme, $\sigma_0^{(k)}=\omega_0^{(k)}$ pour k=0,1,...,2t. Dans un cas où l'équation-clé est résolue avec κ=1 (comme dans l'exemple des figures 13 et 14), on peut même se dispenser du multiplieur 70' et du registre 74' de la cellule $164_0$ puisque $\sigma_0^{(k)}=\omega_0^{(k)}=1$ pour k=0,1,...,2t. Le registre 76 (ou 76') et le multiplexeur 80 (ou 80') des cellules $64_t$ et $112_t$ (ou $164_t$) ne sont également pas nécessaires.

Revenant à la figure 6, le module de calcul de correction 46 comprend deux circuits 120, 122 calculant successivement les valeurs de fonctions pour les éléments $\psi^{-i}$ du corps de Galois (i=N-1,N-2,...,1,0). Le circuit 120 effectue une recherche de Chien pour obtenir les valeurs des polynômes σ(x) et xσ'(x), tandis que le circuit 122 effectue également une recherche de Chien pour obtenir les valeurs de la fonction $x^{l-1}\omega(x)$.

L'algorithme de Forney est mis en oeuvre par le module 46 pour calculer les corrections $e_i$. Un circuit d'inversion 124 reçoit les coordonnées en base duale des quantités $\psi^{-i}\sigma'(\psi^{-i})$ et délivre les inverses de ces quantités exprimés en base standard. Le circuit 124 consiste par exemple en un tableau de mémoire ROM semblable au tableau 103 précédemment décrit en référence à la figure 14. Les m bits de sortie du circuit 124 constituent l'opérande A exprimé en base standard d'un circuit multiplieur 126. L'opérande B en base duale chargé dans le multiplieur 126 est la quantité $\psi^{-i(l-1)}\omega(\psi^{-i})$ délivrée par le circuit 122, retardée dans un registre 128 pour tenir compte du temps de réponse du circuit d'inversion 124. Un circuit de conversion 130 reçoit les coordonnées en base duale délivrées par le multiplieur 126 par groupes successifs de j bits et les convertit en base standard. Les m coordonnées en base standard délivrées par le circuit de conversion 130, qui représentent la correction $e_i$ (relation (11)) lorsque $\sigma(\psi^{-i})=0$, sont adressées à une entrée d'un multiplexeur 132. L'autre entrée du multiplexeur 132 reçoit m bits de niveau 0. Un circuit OU 134 reçoit les m coordonnées binaires en base duale des quantités $\sigma(\psi^{-i})$ retardées dans un registre 136 pour tenir compte du retard introduit par le circuit d'inversion 124, le multiplieur 126 et le circuit de conversion 130. Le bit de sortie du circuit OU 134 (qui vaut 0 quand $\sigma(\psi^{-i})=0$) commande le multiplexeur 132 de façon que la correction $e_i$ soit fournie à l'additionneur 48 par le circuit de conversion 130 si $\sigma(\psi^{-i})=0$ (sinon $e_i=0$).

Le décodeur de la figure 6 a une organisation en pipe-line : pendant que l'équation-clé est résolue par le circuit 44 pour un bloc, le module 42 calcule les syndromes pour le bloc suivant, et le module 46 procède aux corrections pour le bloc précédent. Le retard global introduit par la mémoire FIFO 50 est la somme du temps $\theta_1-\theta_0$ mis par le module 42 pour délivrer les syndromes, du temps $\theta_2-\theta_1$ mis par le circuit 44 pour délivrer les coefficients des polynômes $a(x)$ et $\omega(x)$ et du temps $\theta_3-\theta_2$ mis par le module 46 pour produire une valeur de correction. Pour réduire ce retard global qui donne le temps de réponse du décodeur et pour éviter la nécessité de mémoires tampon dans le module 46, il importe que les circuits de recherche de Chien 120, 122 produisent les valeurs des polynômes avec un débit élevé et un temps de réponse minimal. L'utilisation dans ces circuits 120, 122, ainsi que pour le multiplieur 130, de multiplieurs en base duale avec $j \geq 2$ procure à cet égard un avantage important.

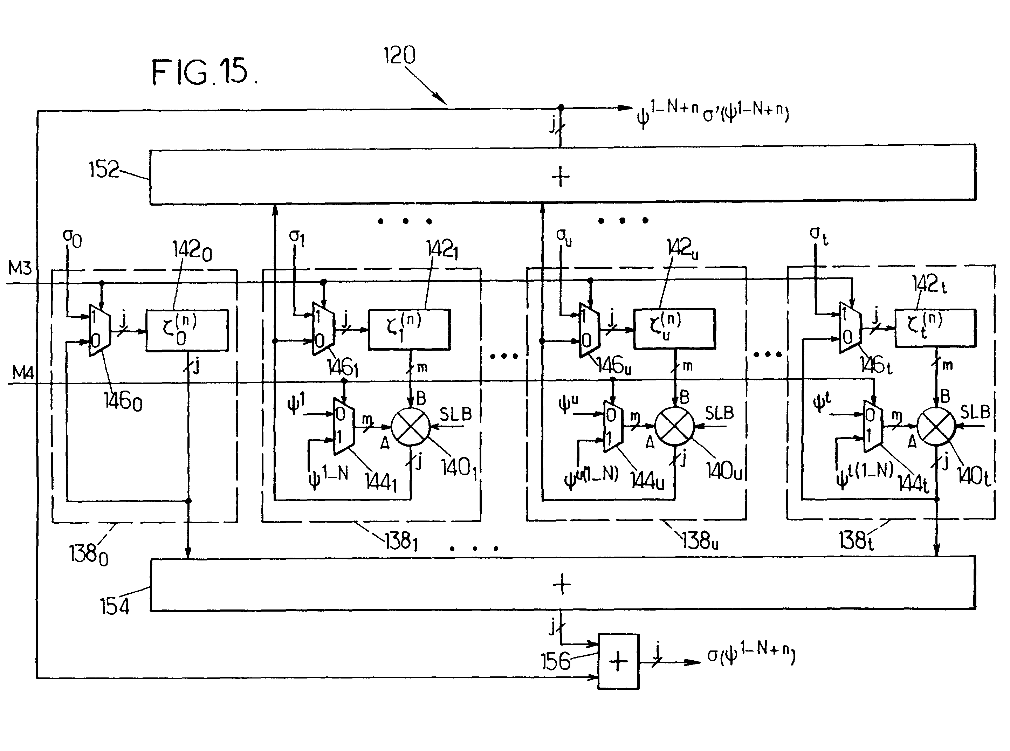

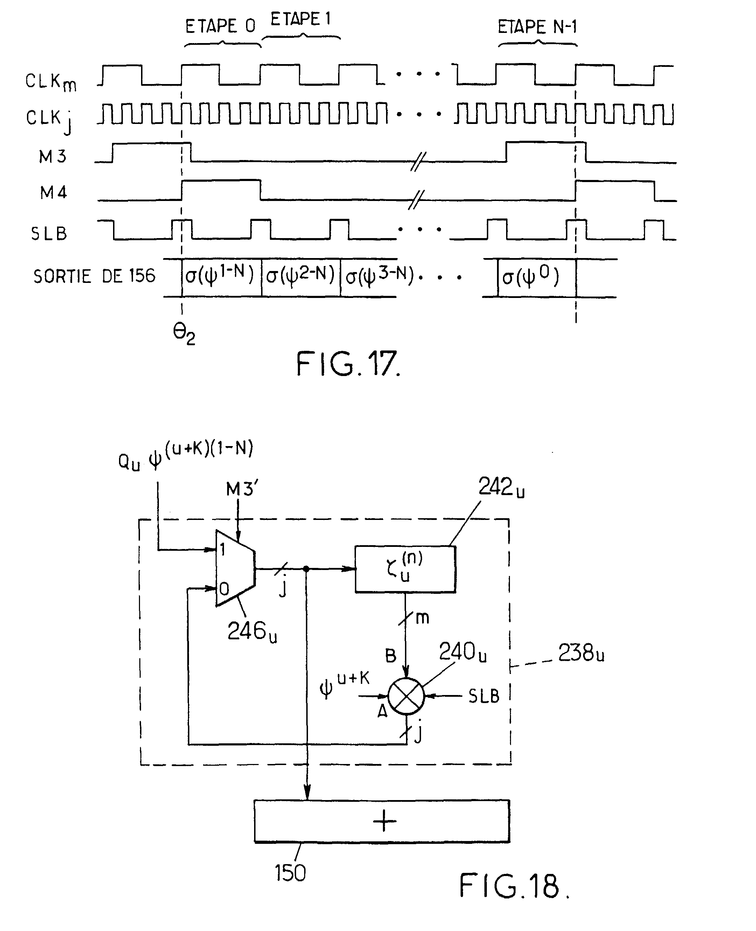

La figure 15 montre la constitution du circuit de recherche de Chien 120. Le circuit 120 comprend t+1 unités de calcul $138_0, 138_1, ..., 138_t$. L'unité de calcul $138_u$ de rang u est agencée pour délivrer les valeurs successives de $\xi_u(n)=\sigma_u.\psi^{u(1+N-n)}$ pour $n=0,1,...,N-1$ (relation (9)). Chaque unité $138_u$ avec $u \geq 1$ comporte un multiplieur en base duale $140_u$, un registre de m bits $142_u$ et deux multiplexeurs $144_u$, $146_u$. Les registres $142_u$ avec $u \geq 1$ sont du type décrit en référence à la figure 5, avec chacun une entrée parallèle sur j bits, et une sortie parallèle sur m bits de type 2 fournissant l'opérande B en base duale au multiplieur $140_u$. Le multiplexeur $146_u$ a une entrée sur j bits reliée à la sortie 9 de la cellule $64_u$ du circuit 44 de résolution de l'équation-clé. Cette entrée du multiplexeur $146_u$ est activée par un signal M3 qui correspond au signal M1 retardé du temps $\theta_2-\theta_1$ (figure 12), de façon que le registre $142_u$ reçoive en m/j groupes successifs de j bits les coordonnées en base duale du coefficient $\sigma_u$ lorsque celles-ci sont délivrées sur la sortie 9 de la cellule $64_u$. L'autre entrée sur j bits du multiplexeur $146_u$, activée lorsque M3=0, est reliée aux j sorties $W_0,...,W_{j-1}$ du multiplieur $140_u$. Le circuit 120 fonctionne en N étapes successives $n=0,1,...,N-1$ à partir de l'instant $\theta_2$ de disponibilité des coefficients $\sigma_u$, chaque étape durant une période de l'horloge symbole $CLK_m$. Le multiplexeur $144_u$ est commandé par un signal M4 (figure 17) pour fournir l'opérande A exprimé en base standard au multiplieur $140_u$, de façon que cet opérande A vaille $\psi^{u(1-N)}$ lors de la première étape n=0 relative à un bloc, et $\psi^u$ lors de chacune des étapes suivantes $n=1,2,...,N-1$. On note que les multiplexeurs $144_u$ ne sont pas nécessaires si $N=2^m-1$ puisqu'alors $\psi^{u(1-N)}=\psi^u$. Comme, pour u=0, $\psi^u=\psi^{u(1-N)}=1$, le multiplieur $140_u$ et le multiplexeur $144_u$ ne sont pas nécessaires dans l'unité de calcul $138_0$ comme le montre la figure 15. Il suffit que le registre $142_0$ ait une sortie parallèle sur j bits (figure 5), le registre $142_0$ étant alimenté par un multiplexeur $146_0$ agencé de la même manière que les multiplexeurs $146_u$.

Lors de chaque étape n ($0 \leq n \leq N-1$), le multiplieur $140_u$ ($1 \leq u \leq t$) délivre les coordonnées en base duale de la quantité $\zeta_u(n)$ définie par la formule (9), et ces coordonnées sont chargées dans le registre $142_u$. Ces coordonnées seront chargées en tant qu'opérande B dans le multiplieur $140_u$ au début de la prochaine étape n+1. Des moyens additionneurs sont prévus pour sommer les quantités $\zeta_u(n)$ délivrées à chaque étape n par le registre $142_0$ et par les multiplieurs $140_u$. Dans l'exemple du circuit 120 représenté sur la figure 15, ces moyens additionneurs comprennent trois additionneurs parallèles sur j bits 152, 154, 156. L'additionneur 152 fait la somme des bits de rangs correspondants des quantités $\zeta_u(n)$ délivrées par les multiplieurs $140_u$ avec u impair. La sortie sur j bits de l'additionneur 152 fournit ainsi, par groupes successifs de j bits, les coordonnées en base duale des valeurs du polynôme $x\sigma'(x)$ pour $x=\psi^{-1}=\psi^{i-N+n}$. L'additionneur 154 fait la somme des bits de rangs correspondants des quantités $\zeta_u(n)$ délivrées par le registre $142_0$ et les multiplieurs $140_u$ avec u pair, et ses j bits de sortie sont ajoutés aux j bits de sortie de l'additionneur 152 par l'additionneur 156. La sortie sur j bits de l'additionneur 156 fournit ainsi, par groupes successifs de j bits, les coordonnées en base duale des valeurs du polynôme $a(x)$ pour $x=\psi^{-i}=\psi^{1-N+n}$. Le temps mis pour fournir toutes les coordonnées de la première valeur des polynômes $\sigma(x)$ et $x\sigma'(x)$ correspond à un seul cycle de l'horloge symbole $CLK_m$ (figure 17).

Le circuit de la figure 15 est généralisable au calcul des valeurs aux points $\psi^{1-N}, \psi^{2-N},..., \psi^{-1}, \psi^0$ de toute fonction de la forme $x^K.Q(x)$ où K est un entier quelconque (positif ou négatif) et $Q(x)$ un polynôme de degré au plus égal à t à coefficients $Q_0, Q_1,..., Q_t$ dans le corps de Galois $CG(2^m)$. Les coefficients $Q_u$ du polynôme $Q(x)$ sont adressés à l'entrée du multiplexeur $146_u$ lorsque M3=1 pour initialiser le calcul. L'élément $\psi^{(u+K)(1-N)}$ est fourni à l'entrée M4=1 du multiplexeur $144_u$, et l'élément $\psi^{u+K}$ est fourni à l'entrée M4=0 du multiplexeur $144_u$, le multiplieur $140_u$ et le multiplexeur $144_u$ n'étant donc pas nécessaires si u=-K. Dans l'exemple de la figure 15, qui permet en outre le calcul des valeurs de $x^{K+1}Q'(x)$, on a K=0 et $Q(x)=\sigma(x)$.

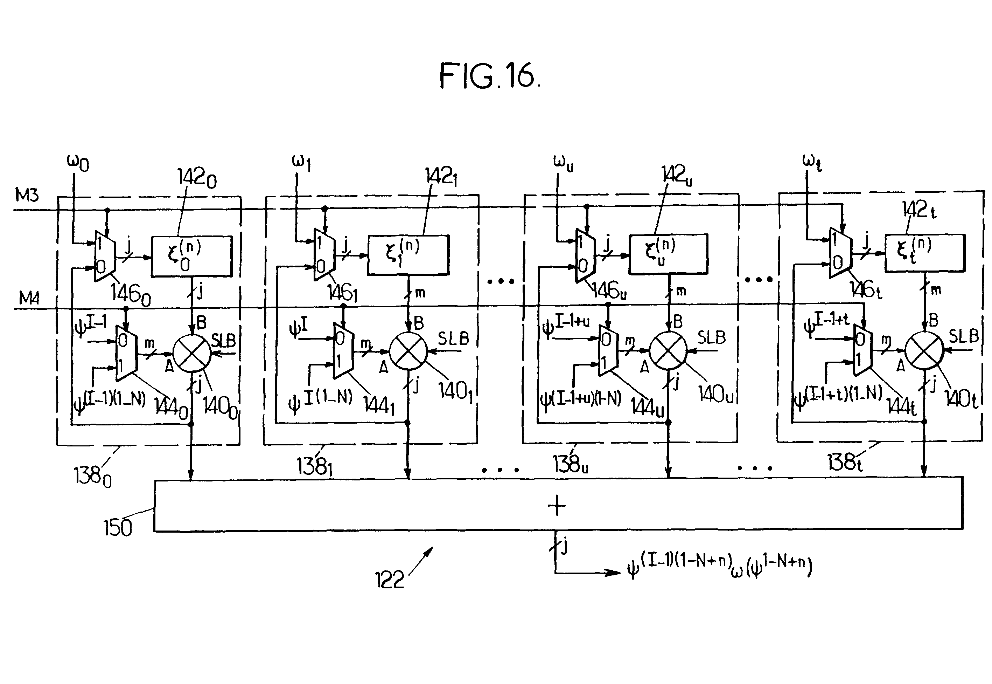

La figure 16 montre le circuit de recherche de Chien 122 utilisé pour calculer les valeurs de la fonction $x^{l-1}\omega(x)$ pour $x=\psi^{1-N},..., \psi^{-1}, \psi^0$. Ce circuit 122 correspond au cas K=l-1, $Q(x)=\omega(x)$. Comme le calcul de dérivée n'est pas utile, les moyens additionneurs comprennent seulement un additionneur parallèle sur j bits 150 faisant la somme des coordonnées en base duale des quantités $\xi_u(n)$ délivrées par les unités de calcul $138_u$ (relation (12)).

Dans les exemples des figures 15 et 16, les opérandes en base standard des multiplieurs $140_u$ sont variables si $N<2m-1$. Pour que ces opérandes soient constants et donc pour simplifier la structure des multiplieurs, les unités de calcul des circuits de recherche de Chien peuvent être conformes à l'unité $238_u$ représentée sur la figure 18. Cette unité $238_u$ comporte un multiplieur $240_u$ dont l'opérande A en base standard est fixe égal à $\psi^{u+K}$, un registre $242_u$ identique au registre $142_u$ pour recevoir la quantité $\zeta_u^{(n)}$ (ou $\xi_u^{(n)}$ lors de l'étape n et la fournir comme opérande B au multiplieur $240_u$ au début de l'étape n+1, et un multiplexeur $246_u$. Le multiplexeur $246_u$ est commandé par un signal M3' correspondant au signal M3 retardé d'un cycle de l'horloge symbole $CKL_m$. Lorsque M3'=0, le produit délivré par le multiplieur $240_u$ est adressé à l'entrée parallèle sur j bits du registre $242_u$. Lorsque M3'=1, l'entrée parallèle sur j bits du registre $242_u$ reçoit, en m/j groupes successifs de j coordonnées binaires sur j bits en base duale, la quantité $Q_u$. $\psi^{(u+K)(1-N)}$. La sortie du j bits du multiplieur $246_u$ est en outre reliée à une entrée respective des moyens additionneurs 150 (ou 152, 154). Si u=-K, l'unité de calcul ne comporte pas de multiplieur et le registre $242_u$ a une sortie parallèle sur j bits reliée à l'entrée (M3'=0) du multiplexeur $246_u$. Lors de l'étape n=0, la quantité $\zeta_u^{(0)}=Q_u.\psi^{(u+K)(1-N)}$ est directement fournie aux moyens additionneurs. Lors de chaque étape n≥1, le multiplieur $240_u$ a $\zeta_u^{(n-1)}$ comme premier opérande, et délivre $\zeta_u^{(n)}$ qui est fourni aux moyens additionneurs.

Une façon d'obtenir $\sigma_u\psi^{u(1-N)}$ à l'entrée du multiplexeur $246_u$ est de prévoir une troisième entrée pour le multiplexeur $66_u$, recevant les m coordonnées en base standard de $\psi^{(1-N)}$, et activée lorsque M3'=1. Le multiplieur 70 de la cellule $64_u$ fournit alors $\sigma_u\psi^{u(1-N)}$ en m/j groupes successifs de j coordonnées en base duale lorsque M3'=1 comme requis à l'entrée du multiplexeur $246_u$. De même, pour fournir $\omega_u\psi^{(l-1+u)(1-N)}$, il suffit de prévoir un multiplexeur à l'entrée 2 de la cellule $112_u$, transmettant $\gamma_{k-1}$ si M3'=0 et la constante $\psi^{(l-1+u)(1-N)}$ si M3'=1, le multiplieur 70 de la cellule $112_u$ fournissant alors $\omega_u\psi^{(l-1+u)(1-N)}$ lorsque M3'=1 comme requis.

Dans les cas où $\psi=\alpha$, l'utilisation de multiplieurs en base duale avec j≥2 n'implique qu'une très faible complexité supplémentaire dans le circuit de recherche de Chien 120 réalisé selon la figure 18. Si en outre l est un petit entier (l=0 par exemple), le circuit de recherche de Chien 122 est également très simplifié.

**Revendications**

1. Circuit multiplieur pour délivrer le produit de premier et second opérandes sur un corps de Galois de cardinal $2^m$, m étant un entier plus grand que 1, le premier opérande A étant représenté, dans une base standard $\{1,\alpha,...,\alpha^{m-1}\}$ du corps de Galois, par m coordonnées binaires $a_0,a_1,...,a_{m-1}$ telles que $A=a_0+a_1\alpha+...+a_{m-1}\alpha^{m-1}$, $\alpha$ désignant une racine d'un polymône générateur $f(x)=x^m+f_{m-1}x^{m-1}+...+f_1x+f_0$ du corps de Galois dont les coefficients $f_0,f_1,...,f_{m-1}$ sont des bits de valeurs prédéterminées, le second opérande B étant représenté, dans une base $\{\beta_0,\beta_1,...,\beta_{m-1}\}$ du corps de Galois qui est une base duale de ladite base standard, par m coordonnées binaires $b'_0,b'_1,...,b'_{m-1}$ telles que $B=b'_0\beta_0+b'_1\beta_1+...+b'_{m-1}\beta_{m-1}$, et le produit C=AB des deux opérandes étant représenté, dans ladite base duale, par m coordonnées binaires $c'_0,c'_1,...,c'_{m-1}$ telles que $C=c'_0\beta_0+c'_1\beta_1+...c'_{m-1}\beta_{m-1}$, caractérisé en ce qu'il comprend :

   j registres à décalage $R_0,R_1,...,R_{j-1}$, j étant un entier plus grand que 1 et désignant un diviseur de m, chaque registre à décalage $R_q$ (0≤q≤j-1) ayant m/j éléments de mémorisation $M_{0,q},M_{1,q},...,M_{(m/j)-1,q}$ agencés de façon que l'entrée de chaque élément de mémorisation $M_{p,q}$ pour 0≤p<(m/j)-1 soit reliée à la sortie de l'élément de mémorisation $M_{p+1,q}$, $z_{p,q}$ désignant le bit présent en sortie de l'élément de mémorisation $M_{p,q}$ pour 0≤p≤(m/j)-1, et $z_{m/j,q}$ désignant le bit présent à l'entrée de l'élément de mémorisation $M_{(m/j)-1,q}$ ;
   des premiers moyens de logique combinatoire (32) pour adresser, à l'entrée de l'élément de mémorisation $M_{(m/j)-1,r}$ de chaque registre à décalage $R_r$ (0≤r≤j-1), un bit respectif $x'_r$ obtenu par l'addition binaire

$$x'_r = \sum_{p=0}^{m/j-1} \sum_{q=0}^{j-1} x_{p,q,r} \ ,$$

   où $x_{p,q,r}=f_{pj+q-r}.z_{p,q}$ si 0≤r≤q, et $x_{p,q,r}=f_{(p+1)j+q-r}.z_{p+1,q}$ si q+1≤r≤j-1 ; et
   des seconds moyens de logique combinatoire (36) pour délivrer, sur chaque sortie $W_r$ (0≤r≤j-1) parmi j sorties $W_0,W_1,...,W_{j-1}$ du circuit multiplieur, un bit respectif $y'_r$ obtenu par l'addition binaire

$$y'_r = \sum_{p=0}^{m/j-1} \sum_{q=0}^{j-1} y_{p,q,r} \quad,$$

où $y_{p,q,r}=a_{pj+q-r}\cdot z_{p,q}$ si $0\leq r\leq q$, et $y_{p,q,r}=a_{(p+1)j+q-r}\cdot z_{p+1,q}$ si $q+1\leq r\leq j-1$,
de sorte qu'en chargeant lors d'un cycle initial k=0 les coordonnées binaires en base duale du second opérande B dans les registres à décalage selon $z_{p,q}=b'_{pj+q}$ pour $0\leq p\leq(m/j)-1$ et $0\leq q\leq j-1$, et en effectuant (m/j)-1 cycles de décalage k=1,...,(m/j)-1 dans lesdits registres, on obtient respectivement les coordonnées binaires en base duale $c'_{kj},c'_{kj+1},...,c'_{kj}+_{(j-1)}$ du produit C sur les sorties $W_0,W_1,...,W_{j-1}$ lors du cycle k $(0\leq k\leq(m/j)-1)$.

2. Circuit multiplieur selon la revendication 1, caractérisé en ce que les premiers moyens de logique combinatoire (32) consistent en des portes OU exclusif (320-325) formant j additionneurs binaires, l'additionneur binaire de rang r $(0\leq r\leq j-1)$ ayant sa sortie reliée à l'entrée de l'élément de mémorisation $M_{(m/j)-1,r}$ et ses entrées respectivement reliées aux sorties des éléments de mémorisation $M_{p,q}$ avec $0\leq p\leq(m/j)-1$, $r\leq q\leq j-1$ et $f_{pj+q-r}=1$ et aux entrées des éléments de mémorisation $M_{p,q}$ avec $0\leq p\leq(m/j)-1$, $0\leq q\leq r-1$ et $f_{(p+1)j+q-r}=1$.

3. Circuit multiplieur selon la revendication 1 ou 2, caractérisé en ce qu'il comporte un second registre de m bits (38) dans lequel les coordonnées en base standard $a_0,a_1,...,a_{m-1}$ du premier opérande A sont initialement chargées, et en ce que les seconds moyens de logique combinatoire (36) comprennent mj portes ET $(34_{p,q\ r})$ pour calculer respectivement les bits $y_{p,q,r}$ avec $0\leq p\leq(m'/j)-1$ et $0\leq q,r\leq j-1$, et des portes OU exclusif (360-373) agencées pour délivrer chaque bit $y'_r (0\leq r\leq j-1)$ en additionnant respectivement les bits $y_{p,q,r}$ pour $0\leq p\leq(m/j)-1$ et $0\leq q\leq j-1$.

4. Circuit multiplieur selon la revendication 1 ou 2, caractérisé en ce que le premier opérande A ayant des coordonnées constantes prédéterminées $a_0,a_1,...,a_{m-1}$ en base standard, les seconds moyens de logique combinatoire (36) consistent en des portes OU exclusif (374,375) formant j additionneurs binaires, l'additionneur binaire de rang r $(0\leq r\leq j-1)$ ayant sa sortie constituant la sortie $W_r$ du circuit multiplieur et ses entrées respectivement reliées aux sorties des éléments de mémorisation $M_{p,q}$ avec $0\leq p\leq(m/j)-1$, $r\leq q\leq j-1$ et $a_{pj+q-r}=1$, et aux entrées des éléments de mémorisation $M_{p,q}$ avec $0\leq p\leq(m/j)-1$, $0\leq q\leq r-1$ et $a_{(p+1)j+q-r}=1$.

5. Circuit de calcul de syndrome fonctionnant en N étapes successives n=0,1,...,N-1 pendant lesquelles sont respectivement reçus des symboles $r_{N-1},r_{N-2},...,r_0$ d'un bloc de signal reçu, chaque symbole étant un élément d'un corps de Galois de cardinal $2^m$, le circuit comprenant :

   - un circuit multiplieur (52) selon la revendication 1 ayant comme premier opérande un élément constant $(\psi^{l+i})$ au corps de Galois pour lequel un syndrome d'erreur $(S_i)$ est à calculer ;
   - un additionneur parallèle sur j bits (54) ayant une première entrée sur j bits recevant lors de chaque étape $n\geq1$ les coordonnées en base duale du symbole $r_{N-1-n}$ sous forme de m/j groupes successifs de j coordonnées binaires de poids croissants, et une seconde entrée sur j bits recevant les j bits présents sur les j sorties $W_0,...,W_{j-1}$ du circuit multiplieur (52) ; et
   - des moyens (56, 58) pour fournir un second opérande au circuit multiplieur pour chacune des N étapes successives, ledit second opérande étant égal au premier symbole $r_{N-1}$ du bloc pour l'étape 1, et ledit second opérande ayant pour chaque étape $n+1\geq2$ des coordonnées binaires en base duale correspondant aux m/j groupes de j bits respectivement délivrés par l'additionneur parallèle (54) lors de la réception des m/j groupes de j coordonnées binaires du symbole $r_{N-1-n}$ au cours de l'étape précédente n,

   les coordonnées en base duale du syndrome étant disponibles en sortie de l'additionneur parallèle (54) au cours de la dernière étape N-1.

6. Circuit de recherche de Chien (120;122) pour calculer en N étapes successives n=0,1,...,N-1 les valeurs, pour N éléments successifs d'un corps de Galois de cardinal $2^m$, d'une fonction de la forme $x^K.Q(x)$ où K est un entier et Q un polynôme de degré au plus égal à t à coefficients dans ledit corps de Galois, lesdits N éléments successifs étant des puissances consécutives $\psi^{1-N}$, $\psi^{2-N},...,\psi^0$ d'un élément primitif $\psi$ du corps de Galois, le circuit comprenant :

   t+1 unités de calcul $(138_0,138_1,...,138_t;238_u)$ de rangs respectifs 0,1,...,t, chaque unité de calcul $(138_u;238_u)$ de rang u $(0\leq u\leq t)$ étant agencée pour délivrer, au cours d'une étape n, m/j groupes successifs de j bits représentant les coordonnées en base duale de l'élément $Q_u.\psi^{(u+K)(1-N+n)}$ du corps de Galois, $Q_u$ désignant le coefficient de degré u dudit polynôme ; et

des moyens additionneurs parallèles sur j bits (152, 154, 156 ; 150) recevant les bits délivrés par chacune desdites unités de calcul $(138_u;238_u)$, de manière à fournir lors de chaque étape n les coordonnées en base duale de la valeur prise par ladite fonction pour l'élément $\psi^{1-N+n}$,

dans lequel chaque unité de calcul $(138_u;238_u)$ de rang u≠-K comporte un circuit multiplieur $(140_u;240_u)$ selon la revendication 1 ayant comme premier opérande l'élément $\psi^{u+K}$ du corps de Galois pour au moins chaque étape n≥1, et comme second opérande le produit entre le coefficient de degré u dudit polynôme et l'élément $\psi^{(u+K)(1-N)}$ du corps de Galois pour l'étape n=1, et, pour chaque étape n≥2, le produit délivré lors de l'étape n-1 par ledit circuit multiplieur $(140_u;240_u)$,

le produit délivré par chaque circuit multiplieur au cours d'une étape n≥1 étant adressé à une entrée parallèle sur j bits respective des moyens additionneurs parallèles.

**7.** Circuit de recherche de Chien (120) selon la revendication 6, caractérisé en ce que les moyens additionneurs parallèles comprennent un additionneur parallèle (152) sur j bits recevant les bits délivrés par les unités de calcul de rang u pour 1≤u≤t et u impair de manière à fournir lors de chaque étape n les coordonnées en base duale de la valeur prise pour l'élément $\psi^{1-N+n}$ par la fonction $x^{K+1}Q'(x)$, Q' désignant la dérivée du polynôme Q.

## Patentansprüche

**1.** Multipliziererschaltung zur Lieferung des Produkts eines ersten und eines zweiten Operanden bei einem Galoischen Körper der Kardinalzahl $2^m$, wobei m eine ganze Zahl größer als 1 ist, wobei der erste Operand A in einer Standardbasis $(1,\alpha,...,\alpha^{m-1})$ des Galoischen Körpers durch m binäre Koordinaten $a_0,a_1,...,a_{m-1}$ dargestellt wird, die so beschaffen sind, daß $A=a_0+a_1\alpha+...+a_{m-1}\alpha^{m-1}$, wobei $\alpha$ eine Wurzel eines Erzeugerpolynoms $f(x) =x^m+f_{m-1}x^{m-1}+...+f_1x+f_0$ des Galoischen Körpers bezeichnet, dessen Koeffizienten $f_0,f_1,...,f_{m-1}$ Bits von vorher festgelegten Werten sind, wobei der zweite Operand B in einer Basis $(\beta_0,\beta_1,...,\beta_{m-1})$ des Galoischen Körpers, die eine Dualbasis der genannten Standardbasis ist, durch m binäre Koordinaten $b'_0,b'_1,...,b'_{m-1}$ dargestellt wird, die so beschaffen sind, daß $B=b'_0\beta_0+b'_1\beta_1+...+b'_{m-1}\beta_{m-1}$, und wobei das Produkt C=AB aus den beiden Operanden in der genannten Dualbasis durch m binäre Koordinaten $c'_0,c'_1,...,c'_{m-1}$ dargestellt wird, die so beschaffen sind, daß $C=c'_0\beta_0+c'_1\beta_1+...+c'_{m-1}\beta_{m-1}$, **dadurch gekennzeichnet,** daß sie umfaßt:

j Schieberegister $R_0,R_1,...,R_{j-1}$, wobei j eine ganze Zahl größer als 1 ist und einen Teiler von m bezeichnet, wobei jedes Schieberegister $R_q$ (0≤q≤j-1) m/j Speicherelemente $M_{0,q},M_{1,q},...,M_{(m/j)-1,q}$ hat, die so eingerichtet sind, daß der Eingang jedes Speicherelements $M_{p,q}$ für 0≤p<(m/j)-1 mit dem Ausgang des Speicherelements $M_{p+1,q}$ verbunden ist, wobei $z_{p,q}$ das am Ausgang des Speicherelements $M_{p,q}$ für 0≤p≤(m/j)-1 vorliegende Bit bezeichnet und $z_{m/j,q}$ das am Eingang des Speicherelements $M_{(m/j)-1,q}$ vorliegende Bit bezeichnet;

erste Mittel der kombinatorischen Logik (32), um an den Eingang des Speicherelements $M_{(m/j)-1,r}$ jedes Schieberegisters $R_r$ (0≤r≤j-1) ein jeweiliges, durch die binäre Addition

$$x'_r = \sum_{p=0}^{m/j-1} \sum_{q=0}^{j-1} x_{p,q,r}$$

erhaltenes Bit $x'_r$ zu adressieren, wobei $x_{p,q,r}=f_{pj+q-r} \cdot z_{p,q}$, wenn 0≤r≤q, und $x_{p,q,r}=f_{(p+1)j+q-r} \cdot z_{p+1,q}$, wenn q+1≤r≤j-1; und

zweite Mittel der kombinatorischen Logik (36), um über jeden Ausgang $W_r$ (0≤r≤j-1) von j Ausgängen $W_0, W_1,...,W_{j-1}$ der Multipliziererschaltung ein jeweiliges, durch die binäre Addition

$$y'_r = \sum_{p=0}^{m/j-1} \sum_{q=0}^{j-1} y_{p,q,r}$$

erhaltenes Bit $y'_r$ zu liefern, wobei $y_{p,q,r}=a_{pj+q-r} \cdot z_{p,q}$, wenn 0≤r≤q, und $y_{p,q,r}=a_{(p+1)j+q-r} \cdot z_{p+1,q}$, wenn q+1≤r≤j-1, so daß, indem bei einem Anfangszyklus k=0 die binären Dualbasis-Koordinaten des zweiten Operanden B in die Schieberegister gemäß $z_{p,q}=b'_{pj+q}$ für 0≤p≤(m/j)-1 und 0≤q≤j-1 geladen und indem (m/j)-1 Verschiebezyklen k=1,...,(m/j)-1 in den genannten Registern ausgeführt werden, die binären Dualbasis-Koordinaten $c'_{kj}, c'_{kj+1}, ..., c'_{kj+(j-1)}$ des Produktes C an den Ausgängen $W_0, W_1, ..., $ bzw. $W_{j-1}$ beim Zyklus k $(0 \leq k \leq (m/j)-1)$ erhalten werden.

2. Multipliziererschaltung nach Anspruch 1, **dadurch gekennzeichnet,** daß die ersten Mittel der kombinatorischen Logik (32) aus Exklusiv-ODER-Gattern (320-325) bestehen, die j binäre Addierer bilden, wobei der binäre Addierer vom Rang r $(0 \leq r \leq j-1)$ an seinem Ausgang mit dem Eingang des Speicherelements $M_{(m/j)-1,r}$ verbunden ist und seine Eingänge mit den Ausgängen der Speicherelemente $M_{p,q}$ mit $0 \leq p \leq (m/j)-1$, $r \leq q \leq j-1$ und $f_{pj+q-r}=1$ bzw. mit den Eingängen der Speicherelemente $M_{p,q}$ mit $0 \leq p \leq (m/j)-1$, $0 \leq q \leq r-1$ und $f_{(p+1)j+q-r}=1$ verbunden sind.

3. Multipliziererschaltung nach Anspruch 1 oder 2, **dadurch gekennzeichnet**, daß sie ein zweites Register mit m Bits (38) enthält, in dem die Standardbasis-Koordinaten $a_0, a_1, ..., a_{m-1}$ des ersten Operanden A zu Beginn geladen werden, und daß die zweiten Mittel der kombinatorischen Logik (36) mj UND-Gatter $(34_{p,q,r})$ zum Berechnen der Bits $y_{p,q,r}$ mit $0 \leq p \leq (m/j)-1$ bzw. $0 \leq q, r \leq j-1$ und Exklusiv-ODER-Gatter (360-373) enthalten, die zur Lieferung jedes Bit $y'_r (0 \leq r \leq j-1)$ eingerichtet sind, indem die Bits $y_{p,q,r}$ r für $0 \leq p \leq (m/j)-1$ bzw. $0 \leq q \leq j-1$ aufaddiert werden.

4. Schaltung nach Anspruch 1 oder 2, **dadurch gekennzeichnet,** daß, wenn der erste Operand A vorher festgelegte, konstante Standardbasis-Koordinaten $a_0, a_1, ..., a_{m-1}$ hat, die zweiten Mittel der kombinatorischen Logik (36) aus j binäre Addierer bildenden Exklusiv-ODER-Gattern (374, 375) bestehen, wobei der Ausgang des binären Addierers vom Rang r $(0 \leq r \leq j-1)$ den Ausgang $W_r$ der Multipliziererschaltung bildet und dessen Eingänge mit den Ausgängen der Speicherelemente $M_{p,q}$ mit $0 \leq p \leq (m/j)-1$, $r \leq q \leq j-1$ und $a_{pj+q-r}=1$ bzw. mit den Eingängen der Speicherelemente $M_{p,q}$ mit $0 \leq p \leq (m/j)-1$, $0 \leq q \leq r-1$ und $a_{(p+1)j+q-r}=1$ verbunden sind.

5. Schaltung zur Syndromberechnung, die in n aufeinanderfolgenden Schritten n=0,1,...,N-1 arbeitet, während denen Symbole $r_{N-1}$, $r_{N-2}, ...$ bzw. $r_0$ eines empfangenen Signalblocks empfangen werden, wobei jedes Symbol ein Element eines Galoischen Körpers der Kardinalzahl $2^m$ ist, wobei die Schaltung umfaßt:

   - eine Multipliziererschaltung (52) gemäß dem Anspruch 1, die als ersten Operanden ein konstantes Element $(\psi^{f+i})$ des Galoischen Körpers hat, für den ein Fehlersyndrom $(S_i)$ zu berechnen ist;
   - einen Paralleladdierer über j Bits (54), der einen ersten Eingang über j Bits, der bei jedem Schritt $n \geq 1$ die Dualbasis-Koordinaten des Symbols $r_{N-1-n}$ in Form von m/j aufeinanderfolgenden Gruppen von j binären Koordinaten von anwachsenden Gewichten empfängt, und einen zweiten Eingang über j Bits hat, der die an den j Ausgängen $W_0, ..., W_{j-1}$ der Multipliziererschaltung (52) vorliegenden j Bits empfängt; und
   - Mittel (56, 58) zum Liefern eines zweiten Operanden an die Multipliziererschaltung für jeden der N aufeinanderfolgenden Schritte, wobei der genannte zweite Operand gleich dem ersten Symbol $r_{N-1}$ des Blocks für den Schritt 1 ist und der genannte zweite Operand für jeden Schritt $n+1 \geq 2$ binäre Dualbasis-Koordinaten hat, die m/j Gruppen mit j Bits entsprechen, die vom Paralleladdierer (54) beim Empfang der m/j Gruppen mit j binären Koordinaten des Symbols $r_{N-1-n}$ im Verlaufe des vorhergehenden Schrittes n jeweils geliefert werden,

   wobei die Dualbasis-Koordinaten des Syndroms am Ausgang des Paralleladdierers (54) im Verlaufe des letzten Schrittes N-1 verfügbar sind.

6. Suchschaltung nach Chien (120;122) zur in N aufeinanderfolgenden Schritten n=0,1,...,N-1 erfolgenden Berechnung der Werte für N aufeinanderfolgende Elemente eines Galoischen Körpers der Kardinalzahl $2^m$ einer Funktion der Form $x^K.Q(x)$, worin K eine ganze Zahl und Q ein Polynom von einem Grad höchstens gleich t mit Koeffizienten im genannten Galoischen Körper ist, wobei die erwähnten N aufeinanderfolgenden Elemente aufeinanderfolgende Potenzen $\psi^{1-N}$, $\psi^{2-N}, ..., \psi^0$ eines Anfangselements $\psi$ des Galoischen Körpers sind, wobei die Schaltung umfaßt:

   t+1 Recheneinheiten $(138_0, 138_1, ..., 138_t; 238_u)$ von jeweiligen aufeinanderfolgenden Rängen 0,1,...,t, wobei jede Recheneinheit $(138_u; 238_u)$ vom Rang u $(0 \leq u \leq t)$ eingerichtet ist, um im Verlaufe eines Schrittes n m/j aufeinanderfolgende Gruppen aus j Bits zu liefern, welche die Dualbasis-Koordinaten des Elements $Q_u \cdot \psi^{(u+K)(1-N-n)}$ des Galoischen Körpers darstellen, wobei $Q_u$ den Koeffizienten vom Grad u des genannten Polynoms bezeichnet; und
   Paralleladdierermittel über j Bits (152, 154, 156; 150), welche die von jeder der genannten Recheneinheiten $(138_u; 238_u)$ gelieferten Bits empfangen, um bei jedem Schritt n die Dualbasis-Koordinaten des durch die genannte Funktion für das Element $\psi^{1-N+n}$ aufgenommen Wertes zu liefern,
   wobei darin jede Recheneinheit $(138_u; 238_u)$ vom Rang $u \neq -K$ eine Multipliziererschaltung $(140_u; 240_u)$ gemäß dem Anspruch 1 aufweist, die als ersten Operanden das Element $\psi^{u+K}$ des Galoischen Körpers für wenigstens jeden Schritt n≥1 und als zweiten Operanden das Produkt aus dem Koeffizienten vom Grad u des genannten Polynoms und dem Element $\psi^{(u+K)(1-N)}$ des Galoischen Körpers für den Schritt n=1 und für jeden Schritt n≥2 das beim Schritt n-1 durch die genannte Multipliziererschaltung ($140_u$; $240_u$) gelieferte Produkt hat, wobei das von jeder Multipliziererschaltung im Verlaufe eines Schrittes n≥1 gelieferte Produkt an einen jeweiligen Paralleleingang über j Bits der Paralleladdierermittel adressiert wird.

**7.** Suchschaltung nach Chien (120) nach Anspruch 6, **dadurch gekennzeichnet,** daß die Paralleladdierermittel einen Paralleladdierer (152) über j Bits umfassen, der die von den Recheneinheiten vom Rang u für 1≤u≤t und ungerades u gelieferten Bits empfängt, um bei jedem Schritt n die Dualbasis-Koordinaten des für das Element $\psi^{1-N+n}$ von der Funktion $x^{K+1}Q'(x)$ aufgenommenen Wertes zu liefern, wobei Q' die Ableitung des Polynoms Q bezeichnet.

## Claims

**1.** Multiplier circuit for delivering the product of first and second operands on a Galois field with cardinal $2^m$, m being an integer greater than 1, the first operand A being represented, in a standard basis $\{1,\alpha,...,\alpha^{m-1}\}$ of the Galois field, by m binary coordinates $a_0,a_1,...,a_{m-1}$ such that $A=a_0+a_1\alpha+...+a_{m-1}\alpha^{m-1}$, a denoting a root of a generating polynomial $f(x)=x^m+f_{m-1}m-1+...+f_1x+f_0$ of the Galois field whose coefficients $f_0,f_1,...,f_{m-1}$ are bits with predetermined values, the second operand B being represented, in a basis $\{\beta_0,\beta_1,...\beta_{m-1}\}$ of the Galois field which is a dual basis of the said standard basis, by m binary coordinates $b'_0,b'_1,...,b'_{m-1}$ such that $B=b'_0\beta_0+b'_1\beta_1+...+b'_{m-1}\beta_{m-1}$, and the product $C=AB$ of the two operands being represented, in the said dual basis, by m binary coordinates $c'_0,c'_1,...,c'_{m-1}$ such that $C = c'_0\beta_0+c'_1\beta_1+...+c'_{m-1}\beta_{m-1}$, characterized in that it comprises:

j shift registers $R_0,R_1,...,R_{j-1}$, j being an integer greater than 1 and designating a divisor of m, each shift register $R_q$ (0≤q≤j-1) having m/j storage elements $M_{0,q},M_{1,q},...,M_{(m/j)-1,q}$ devised in such a way that the input of each storage element $M_{p,q}$ for 0≤p≤(m/j)-1 is linked to the output of the storage element $M_{p+1,q}$, $z_{p,q}$ denoting the bit present at the output of the storage element $M_{p,q}$ for 0≤p≤(m/j)-1, and $z_{m/j,q}$ denoting the bit present at the input of the storage element $M_{(m/j)-1,q}$;

first means of combinatorial logic (32) for addressing, to the input of the storage element $M_{(m/j)-1,r}$ of each shift register $R_r$ (0≤r≤j-1), a respective bit $x'_r$ obtained by the binary addition

$$x'_r = \sum_{p=0}^{m/j-1} \sum_{q=0}^{j-1} x_{p,q,r} \ ,$$

where $x_{p,q,r}=f_{pj+q-r}\cdot z_{p,q}$ if 0≤r≤q, and $x_{p,q,r}=f_{(p+1)j+q-r}\cdot z_{p+1,q}$ if q+1≤r≤j-1; and second means of combinatorial logic (36) for delivering, on each output $W_r$ (0≤r≤j-1) from among j outputs $W_0$, $W_1,..,W_{j-1}$ of the multiplier circuit, a respective bit $y'_r$ obtained by the binary addition

$$y'_r = \sum_{p=0}^{m/j-1} \sum_{q=0}^{j-1} y_{p,q,r} \ ,$$

where $y_{p,q,r}=a_{pj+q-r}\cdot z_{p,q}$ if 0≤r≤q, and $y_{p,q,r}=a_{(p+1)j+q-r}\cdot z_{p+1,q}$ if q+1≤r≤j-1, so that on loading during an initial cycle k=0 the dual-basis binary coordinates of the second operand B into the shift registers according to $z_{p,q}=b'_{pj+q}$ for 0≤p≤(m/j)-1 and 0≤q≤j-1, and by performing (m/j)-1 shift cycles k=1,...,(m/j)-1 in the said registers, the dual-basis binary coordinates $c'_{kj},c'_{kj+1},...,c'_{kj+(j-1)}$ of the product C are obtained respectively on the outputs $W_0,W_1,...,W_{j-1}$ during cycle k (0≤k≤(m/j)-1).

**2.** Multiplier circuit according to Claim 1, characterized in that the first means of combinatorial logic (32) consist of exclusive OR gates (320-325) forming j binary adders, the binary adder of rank r (0≤r≤j-1) having its output linked to the input of the storage element $M_{(m/j)-1,r}$ and its inputs respectively linked to the outputs of the storage elements $M_{p,q}$ with 0≤p≤(m/j)-1, r≤q≤j-1 and $f_{pj+q-r}=1$ and to the inputs of the storage elements $M_{p,q}$ with 0≤p≤(m/j)-1, 0≤q≤r-1 and $f_{(p+1)j+q-r}=1$.

3. Multiplier circuit according to Claim 1 or 2, characterized in that it comprises a second m-bit register (38) into which the standard-basis coordinates $a_0, a_1; ..., a_{m-1}$ of the first operand A are initially loaded, and in that the second means of combinatorial logic (36) comprise mj AND gates ($34_{p,q,r}$) for respectively calculating the bits $y_{p,q,r}$ with $0 \leq p \leq (m/j)-1$ and $0 \leq q, r \leq j-1$, and exclusive OR gates (360-373) devised so as to deliver each bit $y'_r (0 \leq r \leq j-1)$ by respectively adding together the bits $y_{p,q,r}$ for $0 \leq p \leq (m/j)-1$ and $0 \leq q \leq j-1$.

4. Multiplier circuit according to Claim 1 or 2, characterized in that the first operand A having predetermined constant coordinates $a_0, a_1, ..., a_{m-1}$ in the standard basis, the second means of combinatorial logic (36) consist of exclusive OR gates (374,375) forming j binary adders, the binary adder of rank r ($0 \leq r \leq j-1$) having its output constituting the output $W_r$ of the multiplier circuit and its inputs linked respectively to the outputs of the storage elements $M_{p,q}$ with $0 \leq p \leq (m/j)-1$, $r \leq q \leq j-1$ and $a_{pj+q-r}=1$, and to the inputs of the storage elements $M_{p,q}$ with $0 \leq p \leq (m/j)-1$, $0 \leq q \leq r-1$ and $a_{(p+1)j+q-r}=1$.

5. Syndrome calculation circuit operating in N successive steps n=0,1,...,N-1 during which symbols $r_{N-1}$, $r_{N-2},...,r_0$ of a signal block received are respectively received, each symbol being an element of a Galois field with cardinal $2^m$, the circuit comprising:

   - a multiplier circuit (52) according to Claim 1 having as first operand a constant element ($\psi^{l+i}$) of the Galois field for which an error syndrome ($S_i$) is to be calculated;
   - a j-bit parallel adder (54) having a first j-bit input receiving, during each step $n \geq 1$, the dual-basis coordinates of the symbol $r_{N-1-n}$ in the form of m/j successive groups of j binary coordinates with increasing weights, and a second j-bit input receiving the j bits present on the j outputs $W_0,...,W_{j-1}$ of the multiplier circuit (52); and
   - means (56, 58) for supplying a second operand to the multiplier circuit for each of the N successive steps, the said second operand being equal to the first symbol $r_{N-1}$ of the block for step 1, and the said second operand having for each step $n+1 \geq 2$, dual-basis binary coordinates corresponding to the m/j groups of j bits respectively delivered by the parallel adder (54) during the reception of the m/j groups of j binary coordinates of the symbol $r_{N-1-n}$ in the course of the previous step n,

   the dual-basis coordinates of the syndrome being available at the output of the parallel adder (54) in the course of the last step N-1.

6. Chien search circuit (120;122) for calculating in N successive steps n=0,1,...,N-1 the values, for N successive elements of a Galois field with cardinal $2^m$, of a function of the form $x^K.Q(x)$ where K is an integer and Q a polynomial of degree at most equal to t with coefficients in the said Galois field, the said N successive elements being consecutive powers $\psi^{1-N}$, $\psi^{2-N},...,\psi^0$ of a primitive element $\psi$ of the Galois field, the circuit comprising:

   t+1 calculation units ($138_0, 138_1,...,138_t; 238_u$) of respective ranks 0,1,...,t, each calculation unit ($138_u; 238_u$) of rank u ($0 \leq u \leq t$) being devised so as to deliver, in the course of a step n, m/j successive groups of j bits representing the dual-basis coordinates of the element $Q_u \cdot \psi^{(u+K)(1-N+n)}$ of the Galois field, $Q_u$ denoting the coefficient of degree u of the said polynomial; and
   j-bit parallel adder means (152, 154, 156; 150) receiving the bits delivered by each of the said calculation units ($138_u; 238_u$), so as to supply, during each step n, the dual-basis coordinates of the value taken by the said function for the element $\psi^{1-N+n}$
   wherein each calculation unit ($138_u; 238_u$) of rank $u \neq -K$ comprises a multiplier circuit ($140_u; 240_u$) according to Claim 1 having as first operand the element $\psi^{u+K}$ of the Galois field for at least each step $n \geq 1$, and as second operand the product of the coefficient of degree u of the said polynomial and the element $\psi^{(u+K)(1-N)}$ of the Galois field for step n=1, and for each step $n \geq 2$, the product delivered during step n-1 by the said multiplier circuit ($140_u; 240_u$),
   the product delivered by each multiplier circuit in the course of a step $n \geq 1$ being addressed to a respective j-bit parallel input of the parallel adder means.

7. Chien search circuit (120) according to Claim 6, characterized in that the parallel adder means comprise a j-bit parallel adder (152) receiving the bits delivered by the calculation units of rank u for $1 \leq u \leq t$ and u odd so as to supply, during each step n, the dual-basis coordinates of the value taken for the element $\psi^{1-N+n}$ by the function $x^{K+1}Q'(x)$, Q' denoting the derivative of the polynomial Q.

36

$W_{j-1}$

$W_0$

$Y'_{j-1}$

$Y'$

$y'_0$

$+$

$30_{0,j-1}$

$30_{0,0}$

$X_{0,j-1}$

$Z_{0,j-1}$

$X_{0,0}$

$Z_{0,0}$

$R_{j-1}$

$Y_{0,j-1}$

$Y_{0,0}$

$R_0$

$X_{m/j-1,j-1}$

$X_{m/j-1,0}$

$Z_{m/j-1,j-1}$

$Y_{m/j-1,j-1}$

$Z_{m/j-1,0}$

$Y_{m/j-1,0}$

$30_{m/j-1,j-1}$

$30_{m/j-1,0}$

$x'_{j-1}$

$X'$

$x'_0$

$+$

$32$

**FIG.1.**

FIG.2.

$30_{p,q}$

$x_{p,q,q}$

$x_{p,q,0}$

$f_{pj}$

$f_{pj+q}$

$M_{p,q}$

$Z_{p,q}$

$33_{p,q}$

$b'_{pj+q}$  SLB

$34_{p,q,q}$

$34_{p,q,0}$

$a_{pj}$

$a_{pj+q}$

$y_{p,q,q}$

$y_{p,q,0}$

$Y_{p,q}$

$x_{p,q,j-1}$

$f_{pj+q+1}$

$f_{(p+1)j-1}$

$x_{p,q,q+1}$

$a_{pj+q+1}$

$a_{(p+1)j-1}$

$34_{p,q,j-1}$

$34_{p,q,q+1}$

$y_{p,q,j-1}$

$y_{p,q,q+1}$

$X_{p,q}$

FIG.3.

FIG.4.

EP 0 876 645 B1

FIG.5.

FIG.6.

EP 0 876 645 B1

FIG.7.

FIG.8.

FIG.9.

# FIG.10.

# FIG.11.

FIG.12

EP 0 876 645 B1

FIG.13.

FIG.14.

34

FIG.15.

EP 0 876 645 B1

35

# FIG.16.

EP 0 876 645 B1

ETAPE 0   ETAPE 1                    ETAPE N-1

CLK$_m$

CLK$_j$

M3

M4

SLB

SORTIE DE 156 | $\sigma(\psi^{1-N})$ | $\sigma(\psi^{2-N})$ | $\sigma(\psi^{3-N})$ ... | $\sigma(\psi^0)$ |

$\theta_2$

## FIG.17.

$Q_u \, \psi^{(u+K)(1-N)}$

M3′

$242_u$

$\zeta_u^{(n)}$

$246_u$

$238_u$

B

$240_u$

$\psi^{u+K}$

A

SLB

j

150

+

## FIG.18.